# EUROPEAN PATENT APPLICATION

(11) **EP 4 668 341 A1**
(43) Date of publication of application: **24.12.2025**
(21) Application number: 24756223.4
(22) Date of filing: 07.02.2024
(51) Int. Cl.: H01L 31/0216, H01L 31/0224, H01L 31/18, H01L 31/068

(54) **PASSIVATED CONTACT STRUCTURE, SOLAR CELL AND PREPARATION METHOD THEREFOR, AND PHOTOVOLTAIC MODULE**

(30) Priority: 13.02.2023 CN 202310105040
(71) Applicant: Tongwei Solar (Meishan) Co., Ltd., Meishan, Sichuan 620041 (CN)
(72) Inventor: ZHOU, Fan, Meishan, Sichuan 620041 (CN)
(74) Representative: Michalski Hüttermann & Partner Patentanwälte mbB
(86) International application number: PCT/CN2024/076611
(87) International publication number: WO 2024/169850

(57) **Abstract**

The present application relates to a passivated contact structure, a solar cell and a preparation method therefor, and a photovoltaic module. The passivated contact structure comprises a passivation oxide layer arranged close to a silicon wafer of a solar cell and a doped crystalline silicon layer away from the silicon wafer, wherein the thickness of the passivated oxide layer is 1.5 nm to 3.5 nm, and several nanoscale micropores are distributed in the passivated oxide layer.

## Description

### CROSS-REFERENCE TO RELATED APPLICATIONS

This application claims priority to Chinese Patent Application No. 202310105040.1, filed with the Chinese Patent Office on February 13, 2023, entitled " PASSIVATED CONTACT STRUCTURE, SOLAR CELL AND PREPARATION METHOD THEREFOR, AND PHOTOVOLTAIC MODULE", which is incorporated herein by reference in its entirety.

### TECHNICAL FIELD

The present application relates to the field of photovoltaic technology, and in particular, to a passivated contact structure, a solar cell and a preparation method therefor, and a photovoltaic module.

### BACKGROUND

A tunnel oxide passivated contact (TOPCon) solar cell is a type of solar cell that achieves surface passivation through a tunneling and passivated contact structure formed by a tunneling oxide layer and a doped polysilicon layer.

In the current TOPCon solar cell, a thin tunneling oxide layer is necessary to achieve a certain level of conductivity, which, however, may affect the passivation effect and the interface defect density of the solar cell, so that there is a mutual restraint between the conductive property and the passivation property of the solar cell, making it difficult to optimize and enhance both aspects simultaneously.

### SUMMARY

Embodiments of the present application disclose a passivated contact structure, a solar cell and a preparation method therefor, and a photovoltaic module, to solve the problems in conventional technologies that the conductive property and the passivation property of a solar cell are mutually constraining, making it difficult to optimize and enhance both simultaneously.

In a first aspect, embodiments of the present application provide a passivated contact structure for a solar cell. The passivated contact structure includes a passivation oxide layer arranged proximate to a silicon wafer of the solar cell and a doped crystalline silicon layer arranged away from the silicon wafer. A thickness of the passivation oxide layer is 1.5 nm to 3.5 nm. A plurality of nanoscale micropores are distributed in the passivation oxide layer.

Further, a diameter of the micropores is 50 nm to 500 nm.

Further, a quantity of the micropores is 1×10⁴ pores/ cm² to 1.6×10⁸ pores/cm².

Further, the doped crystalline silicon layer is a fragmented crystalline silicon layer doped with a first element and a second element. The first element is phosphorus element or boron element. The second element is at least one of nitrogen element, carbon element, or oxygen element.

Further, a concentration of the second element in the fragmented crystalline silicon layer is greater than 3%.

Further, a band gap of the fragmented crystalline silicon layer is at least 0.3 eV greater than that of the silicon wafer.

Further, a thickness of the fragmented crystalline silicon layer is 40 nm to 200 nm.

Further, a size of a crystalline grain of the fragmented crystalline silicon layer is 30 nm to 100 nm.

In a second aspect, embodiments of the present application provide a solar cell. The solar cell includes:
a silicon wafer having a first surface and a second surface opposite to each other, the first surface being a light-incident surface; and
the passivated contact structure as described in the first aspect, where the passivated contact structure is arranged on the first surface and/or the second surface of the silicon wafer, the passivated contact structure includes a passivation oxide layer arranged proximate to the silicon wafer and a doped crystalline silicon layer arranged away from the silicon wafer, a thickness of the passivation oxide layer is 1.5 nm to 3.5 nm, and a plurality of nanoscale micropores are distributed in the passivation oxide layer.

Optionally, the passivated contact structure is arranged on the second surface of the silicon wafer, with the passivation oxide layer arranged proximate to the second surface and the doped crystalline silicon layer arranged away from the second surface.

Further, the solar cell also includes:
a first diffusion layer and a first functional layer sequentially stacked on the first surface of the silicon wafer, where one of the first diffusion layer and the doped crystalline silicon layer is a P+ type doped layer, and the other of the first diffusion layer and the doped crystalline silicon layer is an N+ type doped layer;
a second functional layer arranged on a side of the doped crystalline silicon layer away from the second surface; and
a third functional layer located on the surface where the P+ type doped layer is arranged, where the third functional layer is arranged between the first functional layer and the first diffusion layer or between the second functional layer and the doped crystalline silicon layer.

Further, the solar cell also includes:
a first electrode forming an ohmic contact with the first diffusion layer; and
a second electrode forming an ohmic contact with the doped crystalline silicon layer.

Optionally, the passivated contact structure is arranged on the first surface of the silicon wafer, with the passivation oxide layer arranged proximate to the first surface and the doped crystalline silicon layer arranged away from the first surface.

Further, the solar cell also includes:
a first functional layer arranged on a side of the doped crystalline silicon layer that is away from the first surface;
a second diffusion layer and a second functional layer sequentially stacked on the second surface of the silicon wafer, where one of the second diffusion layer and the doped crystalline silicon layer is a P+ type doped layer, and the other of the second diffusion layer and the doped crystalline silicon layer is an N+ type doped layer; and
a third functional layer located on the surface where the P+ type doped layer is arranged, where the third functional layer is arranged between the first functional layer and the doped crystalline silicon layer or between the second functional layer and the second diffusion layer.

Further, the solar cell also includes:
a first electrode forming an ohmic contact with the doped crystalline silicon layer; and
a second electrode forming an ohmic contact with the second diffusion layer.

Optionally, the passivated contact structure includes a first passivated contact structure arranged on the first surface of the silicon wafer and a second passivated contact structure arranged on the second surface of the silicon wafer. The first passivated contact structure includes a first passivation oxide layer and a first doped crystalline silicon layer, with the first passivation oxide layer arranged proximate to the first surface and the first doped crystalline silicon layer arranged away from the first surface. The second passivated contact structure includes a second passivation oxide layer and a second doped crystalline silicon layer, with the second passivation oxide layer arranged proximate to the second surface and the second doped crystalline silicon layer arranged away from the second surface. One of the first doped crystalline silicon layer and the second doped crystalline silicon layer is a P+ type doped layer, and the other of the first doped crystalline silicon layer and the second doped crystalline silicon layer is an N+ type doped layer.

Further, the solar cell also includes:
a first functional layer arranged on a side of the first doped crystalline silicon layer away from the first surface;
a second functional layer arranged on a side of the second doped crystalline silicon layer away from the second surface; and
a third functional layer located on the surface where the P+ type doped layer is arranged, where the third functional layer is arranged between the first functional layer and the first doped crystalline silicon layer or between the second functional layer and the second doped crystalline silicon layer.

Further, the solar cell also includes:
a first electrode forming an ohmic contact with the first doped crystalline silicon layer; and
a second electrode forming an ohmic contact with the second doped crystalline silicon layer.

Further, a diameter of the micropores is 50 nm to 500 nm.

Further, a quantity of the micropores is 1×10⁴ pores/cm² to 1.6×10⁸ pores/cm².

Further, the doped crystalline silicon layer is a fragmented crystalline silicon layer doped with a first element and a second element. The first element is phosphorus element or boron element. The second element is at least one of nitrogen element, carbon element, or oxygen element.

Further, a concentration of the second element in the fragmented crystalline silicon layer is greater than 3%.

Further, a band gap of the fragmented crystalline silicon layer is at least 0.3 eV greater than that of the silicon wafer.

Further, a thickness of the fragmented crystalline silicon layer is 40 nm to 200 nm, and a size of a crystalline grain of the fragmented crystalline silicon layer is 30 nm to 100 nm.

Optionally, a morphology of the silicon wafer is a polished surface, a random pyramid textured surface, or an inverted pyramid textured surface.

Optionally, the first functional layer is a silicon nitride layer, a silicon oxynitride layer, or a silicon oxide layer.

Optionally, the second functional layer is at least one of a silicon nitride layer, a silicon oxynitride layer, or a silicon oxide layer.

Optionally, the third functional layer is an aluminum oxide layer.

In a third aspect, embodiments of the present application provide a preparation method for the solar cell described in the second aspect. The preparation method includes the following steps:
preparing the passivated contact structure: forming a dielectric layer and an amorphous film layer on the first surface and/or the second surface of the silicon wafer, and subjecting the silicon wafer formed with the dielectric layer and the amorphous film layer to an annealing treatment, to convert the dielectric layer into the passivation oxide layer and crystallize the amorphous film layer into the doped crystalline silicon layer, wherein a thickness of the passivation oxide layer is 1.5 nm to 3.5 nm, and a plurality of nanoscale micropores are formed in the passivation oxide layer.

Optionally, the step of preparing the passivated contact structure includes:
sequentially depositing the dielectric layer, a first intrinsic layer doped with a second element, a first doped layer doped with a first element, and a mask layer on the silicon wafer, wherein the first intrinsic layer and the first doped layer are the amorphous film layer; and
performing the annealing treatment after the deposition to cause the first intrinsic layer and the first doped layer to collectively form the doped crystalline silicon layer, wherein the doped crystalline silicon layer is a fragmented crystalline silicon layer doped with the first element and the second element, the first element is phosphorus element or boron element, and the second element is at least one of nitrogen element, carbon element, or oxygen element.

Further, in the step of preparing the passivated contact structure, conditions for depositing the dielectric layer include: using a PECVD method, introducing N₂O at 8 SLM to 15 SLM, for a time of 80 s to 200 s.

Further, conditions for depositing the first intrinsic layer include: using a PECVD method, introducing SiH₄, H₂, and YₐO_{b} in a volume ratio of 1:(2 to 4):(0.1 to 1), for a deposition time of 20 s to 120 s, wherein Y in the YₐO_{b} is selected from carbon element, nitrogen element, or oxygen element, a is selected from 0, 1, 2, 3, or 4, and b is selected from 1, 2, 3, or 4.

Further, conditions for depositing the first doped layer include: using a PECVD method, introducing SiH₄, XₘHₙ, and H₂ in a volume ratio of 1:(0.5 to 1):(2 to 4), for a deposition time of 200 s to 600 s, wherein X in the XₘHₙ is selected from phosphorous element or boron element, m is selected from 1 or 2, and n is selected from 3 or 6.

Further, a thickness of the dielectric layer is 1.5 nm to 3.5 nm.

Further, a thickness of the first intrinsic layer is 10 nm to 40 nm.

Further, a thickness of the first doped layer is 50 nm to 100 nm.

Optionally, the step of preparing the passivated contact structure includes:
sequentially depositing the dielectric layer, a first intrinsic layer, a first doped layer doped with a first element, a second intrinsic layer doped with a second element, a second doped layer doped with the first element, and a mask layer on the silicon wafer, wherein the first intrinsic layer, the first doped layer, the second intrinsic layer, and the second doped layer are the amorphous film layer; and
performing the annealing treatment after the deposition to cause the first intrinsic layer, the first doped layer, the second intrinsic layer, and the second doped layer to collectively form the doped crystalline silicon layer, wherein the doped crystalline silicon layer is a fragmented crystalline silicon layer doped with the first element and the second element, the first element is phosphorus element or boron element, and the second element is at least one of nitrogen element, carbon element, or oxygen element.

Further, conditions for depositing the dielectric layer include: using a PECVD method, introducing N₂O at 8 SLM to 15 SLM, for a time of 80 s to 200 s.

Further, conditions for depositing the first intrinsic layer include: using a PECVD method, introducing SiH₄ and H₂ in a volume ratio of 1:(2 to 4), for a deposition time of 20 s to 120 s.

Further, conditions for depositing the first doped layer include: using a PECVD method, introducing SiH₄, XₘHₙ, and H₂ in a volume ratio of 1:(0.5 to 1):(2 to 4), for a deposition time of 200 s to 350 s, wherein X in the XₘHₙ is selected from phosphorous element or boron element, m is selected from 1 or 2, and n is selected from 3 or 6.

Further, conditions for depositing the second intrinsic layer include: using a PECVD method, introducing SiH₄, H₂, and YₐO_{b} in a volume ratio of 1:(2 to 4):(0.1 to 1), for a deposition time of 20 s to 120 s, wherein Y in the YₐO_{b} is selected from carbon element, nitrogen element, or oxygen element, a is selected from 0, 1, 2, 3, or 4, and b is selected from 1, 2, 3, or 4.

Further, conditions for depositing the second doped layer include: using a PECVD method, introducing SiH₄, XₘHₙ, and H₂ in a volume ratio of 1:(0.5 to 1):(2 to 4), for a deposition time of 200 s to 350 s, wherein X in the XₘHₙ is selected from phosphorous element or boron element, m is selected from 1 or 2, and n is selected from 3 or 6.

Further, a thickness of the dielectric layer is1.5 nm to 3.5 nm.

Further, a thickness of the first intrinsic layer is 5 nm to 40 nm.

Further, a thickness of the first doped layer is 20 nm to 60 nm.

Further, a thickness of the second intrinsic layer is 5 nm to 40 nm.

Further, a thickness of the second doped layer is 20 nm to 60 nm.

Further, in the step of preparing the passivated contact structure, the dielectric layer and the amorphous film layer are deposited at a temperature of 350°C to 500°C for a deposition time of 30 min to 60 min. A temperature of the annealing treatment is 930°C to 1050°C. A time of the annealing treatment is 50 min to 170 min.

Further, the preparation method also includes performing a pre-deposition step before the step of preparing the passivated contact structure, where the pre-deposition step involves pre-depositing the dielectric layer through a wet process.

Further, the pre-deposition step involves pre-depositing the dielectric layer with a thickness of 0.3 nm to 0.7 nm on the silicon wafer through the wet process for a pre-deposition time of 2 min to 5 min.

Optionally, the step of preparing the passivated contact structure involves sequentially forming the dielectric layer and the amorphous film layer on the second surface of the silicon wafer, followed by the annealing treatment to form a passivation oxide layer proximate to the second surface and a doped crystalline silicon layer away from the second surface;
the preparation method further includes a pre-treatment step before the step of preparing the passivated contact structure, wherein the pre-treatment step involves preparing a first diffusion layer on the first surface of the silicon wafer, one of the first diffusion layer and the doped crystalline silicon layer is a P+ type doped layer, and the other of the first diffusion layer and the doped crystalline silicon layer is an N+ type doped layer;
the preparation method further includes a post-treatment step after the step of preparing the passivated contact structure, and the post-treatment step involves: forming a first functional layer on the first diffusion layer and forming a second functional layer on the doped crystalline silicon layer; forming a third functional layer on the surface where the P+ type doped layer is arranged, with the third functional layer arranged between the first functional layer and the first diffusion layer or between the second functional layer and the doped crystalline silicon layer; and forming a first electrode in an ohmic contact with the first diffusion layer, and forming a second electrode in an ohmic contact with the doped crystalline silicon layer.

Optionally, the step of preparing the passivated contact structure involves sequentially forming the dielectric layer and the amorphous film layer on the first surface of the silicon wafer followed by the annealing treatment to form a passivation oxide layer proximate to the first surface and a doped crystalline silicon layer away from the first surface; and
the preparation method further includes a post-treatment step after the step of preparing the passivated contact structure, and the post-treatment step involves: preparing a second diffusion layer on the second surface of the silicon wafer, wherein one of the second diffusion layer and the doped crystalline silicon layer is a P+ type doped layer, and the other of the second diffusion layer and the doped crystalline silicon layer is an N+ type doped layer; forming a first functional layer on the doped crystalline silicon layer and forming a second functional layer on the second diffusion layer; forming a third functional layer on the surface where the P+ type doped layer is arranged, with the third functional layer arranged between the first functional layer and the doped crystalline silicon layer or between the second functional layer and the second diffusion layer; and forming a first electrode in an ohmic contact with the doped crystalline silicon layer, and forming a second electrode in an ohmic contact with the second diffusion layer.

Optionally, the step of preparing the passivated contact structure includes: forming the dielectric layer and the amorphous film layer on each of the first surface and the second surface of the silicon wafer followed by an annealing treatment to form a first passivated contact structure arranged on the first surface and a second passivated contact structure located on the second surface, wherein the first passivated contact structure includes a first passivation oxide layer proximate to the first surface and a first doped crystalline silicon layer away from the first surface, the second passivated contact structure includes a second passivation oxide layer proximate to the second surface and a second doped crystalline silicon layer away from the second surface, one of the first doped crystalline silicon layer and the second doped crystalline silicon layer is a P+ type doped layer, and the other of the first doped crystalline silicon layer and the second doped crystalline silicon layer is an N+ type doped layer; and
the preparation method further includes a post-treatment step after the step of preparing the passivated contact structure, and the post-treatment step involves: forming a first functional layer on the first doped crystalline silicon layer and forming a second functional layer on the second doped crystalline silicon layer; forming a third functional layer on the surface where the P+ type doped layer is arranged, with the third functional layer arranged between the first functional layer and the first doped crystalline silicon layer or between the second functional layer and the second doped crystalline silicon layer; and forming a first electrode in an ohmic contact with the first doped crystalline silicon layer, and forming a second electrode in an ohmic contact with the second doped crystalline silicon layer.

In a fourth aspect, embodiments of the present application provide a photovoltaic module, including the solar cell described in the second aspect.

Compared with the conventional technologies, the present application has the following beneficial effects:
In the embodiments of the present application, by modifying the passivated contact structure of the solar cell, both the conductivity and the passivation effect of the silicon wafer can be enhanced. In the embodiments of the present application, as the thickness of the passivation oxide layer is increased to the range of 1.5 nm to 3.5 nm, compared with a tunneling oxide layer with a thickness less than 1.5 nm, the increased thickness may reduce the interface defect density of the silicon wafer, thereby optimizing the passivation effect on an interface of the silicon wafer. Meanwhile, although the increased thickness tends to cause a significant reduction in the tunneling probability of the majority carriers, since a plurality of fine pinholes with a size at nanoscale are provided in the passivation oxide layer while increasing the thickness of said layer in the embodiments of the present application, carrier conducting channels are created between the silicon wafer and the doped crystalline silicon layer due to the presence of these pinholes, transforming the previous tunneling conduction of the passivated contact structure to direct conduction, thereby reducing the series resistance of carrier transport and improving the conductivity. As can be seen that in the embodiments of the present application, by increasing the thickness of the passivation oxide layer in the passivated contact structure while forming the nanoscale micropores in the passivation oxide layer, both the conductivity and the passivation effect of the solar cell can be enhanced.

### BRIEF DESCRIPTION OF THE DRAWINGS

In order to describe technical solutions in embodiments of the present application more clearly, accompanying drawings required to be used in the embodiments will be briefly described below, it is apparent that the accompanying drawings described below are only some embodiments of the present application, and those of ordinary skill in the art may also derive other accompanying drawings according to these accompanying drawings without creative work.
FIG. 1 is a schematic structural view of a solar cell according to Example 1 of the present application;
FIG. 2 is a scanning electron microscope (SEM) image of a passivation oxide layer in the solar cell according to Example 1 of the present application;
FIG. 3 is a schematic view of a conduction principle of the passivation oxide layer in the solar cell according to Example 1 of the present application;
FIG. 4 is a flowchart of a preparation method for the solar cell according to Example 1 of the present application;
FIG. 5 is a schematic structural view of a solar cell according to Example 9 of the present application;
FIG. 6 is a flowchart of a preparation method for the solar cell according to Example 9 of the present application;
FIG. 7 is a schematic structural view of a solar cell according to Example 10 of the present application; and
FIG. 8 is a flowchart of a preparation method for the solar cell according to Example 10 of the present application.

Reference numerals:
1-silicon wafer; 21-first diffusion layer; 22-second diffusion layer; 3-first functional layer; 4-second functional layer; 5-passivated contact structure; 5a-passivation oxide layer; 5b-doped crystalline silicon layer; 511-micropore; 51-first passivated contact structure; 51a-first passivation oxide layer; 51b-first doped crystalline silicon layer; 52-second passivated contact structure; 52a-second passivation oxide layer; 52b-second doped crystalline silicon layer; 6-third functional layer; 7-first electrode; and 8-second electrode.

### DETAILED DESCRIPTION

The technical solutions in embodiments of the present application are clearly and completely described in the following with reference to the accompanying drawings in the embodiments of the present application. Apparently, the described embodiments are merely some rather than all of the embodiments of the present application. All other embodiments obtained by a person of ordinary skill in the art based on the embodiments of the present application without creative efforts shall fall within the protection scope of the present application.

In the present application, the orientation or positional relationships indicated by the terms such as "upper", "lower", "left", "right", "front", "rear", "top", "bottom", "inner", "outer", "middle", "vertical", "horizontal", "transverse", and "longitudinal" are based on the orientation or positional relationships shown in the accompanying drawings. These terms are mainly used to better describe the present application and the embodiments thereof, and are not intended to limit the indicated apparatuses, elements, or components to have specific orientations or to require construction and operation in specific orientations.

Moreover, some of the above-mentioned terms may also be used to represent other meanings in addition to indicating the orientation or positional relationships. For example, the term "on" may, in certain cases, be used to indicate a certain attachment relationship or connection relationship. Those of ordinary skill in the art should understand the specific meanings of these terms in the present application according to specific situations.

Further, the terms "installed", "arranged", "provided with", "connected", and "coupled" should be understood in a broad sense. For example, it may be a fixed connection, a detachable connection, or an integrated construction; it may be a mechanical connection or an electrical connection; or it may be a direct connection, an indirect connection through an intermediate medium, or a communication between interiors of two apparatuses, elements, or components. Those of ordinary skill in the art should understand the specific meanings of the above-mentioned terms in the present application according to specific situations.

Further, the terms "first", "second", etc., are mainly used to distinguish between different apparatuses, elements, or components (specific categories and constructions may be the same or different), and are not intended to indicate or imply relative importance and quantity of the indicated apparatuses, elements, or components. Unless otherwise stated, "a plurality of" means two or more than two.

Further, reagents such as hydrofluoric acid, sodium hydroxide solution, and various types of additives used in a preparation method for a solar cell in the embodiments of the present application can all be obtained through commercial purchase, and no limitations are imposed herein.

The technical solutions of the present application will be further described below in conjunction with the embodiments and the accompanying drawings.

A TOPCon solar cell can achieve good passivation effect on both P-type and N-type surfaces by utilizing a passivated contact structure. Additionally, due to carrier transport mechanisms such as tunneling, the passivated contact structure may also exhibit a low contact resistance with the surface of the silicon wafer. In other words, the passivated contact structure can function both as a surface passivation layer and a carrier-conducting and connecting layer, thereby reducing recombination between the metal regions and the carriers.

In the related art, the passivated contact structure includes a tunneling oxide layer and a doped polysilicon layer. In order to achieve tunneling conduction of majority carriers, the tunneling oxide layer needs to be provided at a relatively thin thickness, such as 0.8 nm to 1.4 nm. However, under such thickness condition, there remains a need for optimization and improvement in the passivation effect and the interface defect density of the tunneling oxide layer. However, if the thickness of the tunneling oxide layer is increased, the tunneling probability of the majority carriers would be decreased exponentially. If the tunneling oxide layer is provided at a thickness greater than or equal to 1.5 nm, although the passivation effect and the interface defect density thereof can be optimized, the tunneling probability of the majority carriers would be significantly decreased, leading to significantly increased series resistance of the majority-carrier transport and affecting the conductivity of the silicon wafer. For example, when the thickness of the tunneling oxide layer is 1 nm, the tunneling probability of this layer is approximately 2.04%. However, when the thickness of the tunneling oxide layer is increased to 2 nm, the tunneling probability of this layer is decreased to only about 0.05%, failing to achieve effective tunneling of the majority carriers. It can be seen that for the passivation oxide layer, its conductivity and passivation effect are two performance indicators that mutually constrain and influence one another, as a result, achieving better conductivity and passivation effect simultaneously is difficult, regardless of the layer's thickness. In other words, in the related art, the thickness of the tunneling oxide layer can only be provided to achieve a balance between conductivity and passivation effect, however, neither the conductivity nor the passivation effect reaches its optimal value. Consequently, optimizing and enhancing these two mutually constrained performance aspects simultaneously is difficult.

Based on the above-mentioned analysis, embodiments of the present application provide a passivated contact structure, a solar cell and a preparation method therefor, and a photovoltaic module, which can solve the problem of the mutual constraint between the conductivity and the passivation effect caused by the tunneling oxide layer, and optimize and enhance these two performance aspects.

In a first aspect, embodiments of the present application provide a passivated contact structure for a solar cell, including a passivation oxide layer arranged proximate to a silicon wafer of the solar cell and a doped crystalline silicon layer arranged away from the silicon wafer. A thickness of the passivation oxide layer is 1.5 nm to 3.5 nm. A plurality of nanoscale micropores are distributed in the passivation oxide layer.

In the embodiments of the present application, by modifying the passivated contact structure of the solar cell, both the conductivity and the passivation effect of the silicon wafer can be enhanced. In the embodiments of the present application, as the thickness of the passivation oxide layer is increased to the range of 1.5 nm to 3.5 nm, compared with a tunneling oxide layer with a thickness less than 1.5 nm, the increased thickness may reduce the interface defect density of the silicon wafer, thereby optimizing the passivation effect on an interface of the silicon wafer. Meanwhile, although the increased thickness tends to cause a significant reduction in the tunneling probability of the majority carriers, since a plurality of fine pinholes with a size at nanoscale are provided in the passivation oxide layer while increasing the thickness of said layer in the embodiments of the present application, direct conducting channels are created between the silicon wafer and the doped crystalline silicon layer due to the presence of these pinholes, transforming the previous tunneling conduction of the passivated contact structure to direct conduction, thereby reducing the series resistance of carrier transport and improving the conductivity.

As can be seen that in the embodiments of the present application, by increasing the thickness of the passivation oxide layer in the passivated contact structure while forming the nanoscale micropores in the passivation oxide layer, the previous approach of achieving conduction through tunneling is transformed into a direct conduction approach where carriers pass directly through the micropores to achieve conduction, so that both the conductivity and the passivation effect of the solar cell can be enhanced.

The solar cell is a TOPCon solar cell. The silicon wafer is an N-type silicon wafer. Additionally, the nanoscale micropores refer to pores with a size specification in nanometers, meaning that the micropores are not large openings but rather fine pores. The nanoscale micropores are used to provide effective conducting channels for the smooth passage of carriers, thereby solving the problem that the carriers struggle to pass through the passivation oxide layer due to the increased thickness of the passivation oxide layer.

Exemplarily, the thickness of the passivation oxide layer being 1.5 nm to 3.5 nm includes any point value within this thickness range, for example, the thickness of the passivation oxide layer is 1.5 nm, 1.6 nm, 1.8 nm, 2.0 nm, 2.2 nm, 2.4 nm, 2.5 nm, 2.8 nm, 3.0 nm, 3.2 nm, or 3.5 nm. Within this thickness range, it is conducive to improving both the conductive property and the passivation property of the solar cell. Whereas, when the thickness is less than 1.5 nm, the passivation oxide layer is relatively thin, resulting in a poor passivation effect. When the thickness is greater than 3.5 nm, the excessive thickness of the film layer increases the difficulty of cracking film layer of the passivation oxide layer and thus forming micropores, leading to insufficient micropore formation, which fails to meet the requirement of providing direct conducting channels for carriers.

Optionally, a diameter of the micropores is 50 nm to 500 nm. Optionally, a quantity of the micropores is 1×10⁴ pores/cm² to 1.6×10⁸ pores/cm². When the diameter and the quantity of the micropores are controlled within the above-mentioned ranges, on one hand, it is conducive to ensuring a good conductivity, and on the other hand, it is conducive to stabilizing the passivation effect, preventing excessive and oversized pores from adversely affecting the passivation effect, and preventing excessively fine and insufficient pores from impacting the carrier conductivity, which may lead to an increase in series resistance of carrier transport.

Exemplarily, the diameter of the micropores being 50 nm to 500 nm includes any point value within this diameter range, for example, the diameter of the micropores is 50 nm, 60 nm, 80 nm, 100 nm, 150 nm, 200 nm, 250 nm, 300 nm, 350 nm, 400 nm, 450 nm, or 500 nm. The quantity of the micropores being 1×10⁴ pores/cm² to 1.6×10⁸ pores /cm² includes any point value within this numerical range, such as 1×10⁴ pores/cm², 5×10⁴ pores/cm², 1×10⁵ pores/cm², 5×10⁵ pores/cm², 1×10⁶ pores/cm², 5×10⁶ pores/cm², 1×10⁷ pores/cm², 5×10⁷ pores/cm², 1×10⁸ pores/cm², or 1.6×10⁸ pores/cm².

Further, the doped crystalline silicon layer may be a polysilicon layer doped with phosphorus element or boron element, or may alternatively be a fragmented crystalline silicon layer doped with more different elements. When the doped crystalline silicon layer is the polysilicon layer doped with phosphorus element or boron element, it can cause band bending and prevents minority carriers in the silicon wafer from diffusing to the surface of the silicon wafer, thereby reducing the probability of recombination between metals and minority carriers on the surface, and then extending the lifetime of minority carriers in this structure. Meanwhile, due to the high concentration doping of phosphorus element or boron element, the polysilicon layer itself also possesses a low transport resistance.

However, the polysilicon material has the characteristics of a narrow band gap and a narrow optical window, and when the polysilicon material is used as a passivation film, a portion of sunlight is absorbed by this film, which affects the photoelectric conversion efficiency of the solar cell. To further improve the photoelectric conversion efficiency of the solar cell, on the basis of modifying the passivation oxide layer, the doped crystalline silicon layer is further modified in the embodiments of the present application, with the fragmented crystalline silicon layer doped with more different elements as the doped crystalline silicon layer. Specifically, the doped crystalline silicon layer is a fragmented crystalline silicon layer doped with a first element and a second element, with the first element being phosphorus element or boron element, and the second element being at least one of nitrogen element, carbon element, or oxygen element.

In this way, the doping of the first element in the fragmented crystalline silicon layer can cause band bending, thereby prolonging the lifetime of minority carriers in this structure. When the phosphorus element is used as the first element, the diffusion of holes in the silicon wafer to the surface of the silicon wafer can be blocked, thereby reducing the probability of recombination between the metals and the holes on the surface. When the boron element is used as the first element, the diffusion of electrons in the silicon wafer to the surface of the silicon wafer is blocked, thereby reducing the probability of recombination between the metals and the electrons on the surface. Meanwhile, compared to polysilicon, the fragmented crystalline silicon has a larger number of crystalline grain boundaries, thereby facilitating the diffusion of the nitrogen element, the carbon element, or the oxygen element as the second element into the fragmented crystalline silicon layer. On the other hand, the doping and diffusion of the second element into the fragmented crystalline silicon layer broaden the band gap of the fragmented crystalline silicon layer, which helps reduce parasitic absorption and improve the photoelectric conversion efficiency of the solar cell.

Further, a concentration of the second element in the fragmented crystalline silicon layer is greater than 3%. A band gap of the fragmented crystalline silicon layer is at least 0.3 eV greater than that of the silicon wafer. When the doping concentration of the second element such as nitrogen element, carbon element, or oxygen element in the fragmented crystalline silicon layer is greater than 3%, the improvement in the band gap of the fragmented crystalline silicon layer is more significant, with the band gap of the fragmented crystalline silicon layer being at least 0.3 eV greater than that of the silicon wafer and being at least 0.15 eV greater than that of the polysilicon layer undoped with the second element. Exemplarily, the concentration of the second element in the fragmented crystalline silicon layer greater than 3% includes any point value within this concentration range, for example, the concentration of the second element in the fragmented crystalline silicon layer is 3.1%, 3.3%, 3.5%, 3.6%, 3.8%, 4.0%, 4.5%, 4.8%, 5.0%, 5.5%, or 6%. It should be understood that the concentration may be measured through an X-ray energy-dispersive spectrometer (EDS).

Further, a thickness of the fragmented crystalline silicon layer is 40 nm to 200 nm. A size of a crystalline grain of the fragmented crystalline silicon layer is 30 nm to 100 nm. When the thickness and the crystalline grain size of the fragmented crystalline silicon layer are controlled within the above-mentioned ranges, it is conducive to a balance between the structural stability of the fragmented crystalline silicon layer, a difficulty level of doping of the first element and the second element, and the impact of optical absorption on the solar cell, thereby preventing silver paste from burning through the fragmented crystalline silicon layer when performing a fabrication process on the fragmented crystalline silicon layer, also avoiding excessive sunlight absorption that may influence the photoelectric conversion efficiency when the layer is too thick, and also promoting easier doping and diffusion of the first element and the second element into the fragmented crystalline silicon layer with an appropriate crystalline grain size. Exemplarily, the thickness of the fragmented crystalline silicon layer being 40 nm to 200 nm includes any point value within this numerical range, for example, the thickness of the fragmented crystalline silicon layer is 40 nm, 50 nm, 80 nm, 100 nm, 120 nm, 150 nm, 180 nm, or 200 nm. Exemplarily, the crystalline grain size of the fragmented crystalline silicon layer being 30 nm to 100 nm includes any point value within this numerical range, for example, the crystalline grain size of the fragmented crystalline silicon layer is 30 nm, 40 nm, 50 nm, 60 nm, 70 nm, 80 nm, 90 nm, or 100 nm.

In a second aspect, embodiments of the present application provide a solar cell adopting the passivated contact structure in the first aspect, including:
a silicon wafer having a first surface and a second surface opposite to each other, with the first surface being a light-incident surface; and
a passivated contact structure arranged on the first surface and/or the second surface of the silicon wafer, the passivated contact structure including a passivation oxide layer proximate to the silicon wafer and a doped crystalline silicon layer away from the silicon wafer, a thickness of the passivation oxide layer being 1.5 nm to 3.5 nm, and a plurality of nanoscale micropores being distributed in the passivation oxide layer.

Since the silicon wafer of the solar cell is provided with the passivated contact structure described in the first aspect thereon, not only the passivation effect on an interface of the silicon wafer can be optimized through the thickened passivation oxide layer, meanwhile, but also the nanoscale micropores distributed in the passivation oxide layer can be used to provide conducting channels for direct passage of majority carriers, transforming the tunneling conduction into direct conduction, thereby reducing series resistance of majority-carrier transport and improving the conductivity.

The silicon wafer is provided with the first surface and the second surface opposite to each other. The first surface is the light-incident surface. That is, the first surface is a surface exposed to sunlight irradiation, which may also be understood as a front surface of the silicon wafer. The second surface is a surface opposite to the light-incident surface, which may also be understood as a back surface of the silicon wafer. The passivated contact structure may be arranged only on the first surface of the silicon wafer, or only on the second surface of the silicon wafer, or on both the first surface and the second surface of the silicon wafer.

As an optional embodiment, the passivated contact structure may be arranged only on the second surface of the silicon wafer, namely, the back surface of the silicon wafer. In this embodiment, the passivated contact structure is arranged on the second surface of the silicon wafer, the passivation oxide layer in the passivated contact structure is arranged proximate to the second surface, and the doped crystalline silicon layer in the passivated contact structure is arranged away from the second surface. The solar cell further includes: a first diffusion layer and a first functional layer sequentially stacked on the first surface of the silicon wafer, where one of the first diffusion layer and the doped crystalline silicon layer is a P+ type doped layer, and the other of the first diffusion layer and the doped crystalline silicon layer is an N+type doped layer; a second functional layer arranged on a side of the doped crystalline silicon layer away from the second surface; and a third functional layer located on the surface on which the P+ type doped layer is arranged, the third functional layer being arranged between the first functional layer and the first diffusion layer, or the third functional layer being arranged between the second functional layer and the doped crystalline silicon layer.

Further, the solar cell further includes: a first electrode that penetrates through the anti-reflection layer and the third functional layer to form an ohmic contact with the first diffusion layer; and a second electrode that penetrates through the second passivation layer to form an ohmic contact with the doped crystalline silicon layer.

In the structure of the above-mentioned solar cell, by arranging the passivated contact structure described in the first aspect on the second surface of the silicon wafer (i.e., the back surface of the silicon wafer), both the conductivity and the passivation effect of the solar cell can be effectively improved. One of the first diffusion layer and the doped crystalline silicon layer being the P+ type doped layer and the other of the first diffusion layer and the doped crystalline silicon layer being the N+ type doped layer includes two cases: firstly, when the first diffusion layer is the P+ type doped layer, the doped crystalline silicon layer is accordingly the N+ type doped layer; and secondly, when the first diffusion layer is the N+ type doped layer, the doped crystalline silicon layer is accordingly the P+ type doped layer. When the first diffusion layer is the P+ type doped layer, the third functional layer is arranged between the first functional layer and the first diffusion layer to provide corresponding passivation and protection for the P+ type doped layer. In this case, the first electrode penetrates through the first functional layer and the third functional layer to form the ohmic contact with the first diffusion layer, and the second electrode penetrates through the second functional layer to form the ohmic contact with the doped crystalline silicon layer. When the doped crystalline silicon layer is the P+ type doped layer, the third functional layer is arranged between the second functional layer and the doped crystalline silicon layer to provide corresponding passivation and protection for the P+ type doped layer. In this case, the first electrode penetrates through the first functional layer to form the ohmic contact with the first diffusion layer, and the second electrode penetrates through the second functional layer and the third functional layer to form the ohmic contact with the doped crystalline silicon layer.

As another optional embodiment, the passivated contact structure may be arranged only on the first surface of the silicon wafer, namely, the front surface of the silicon wafer. In this embodiment, the passivated contact structure is arranged on the first surface of the silicon wafer, the passivation oxide layer in the passivated contact structure is arranged proximate to the first surface, and the doped crystalline silicon layer in the passivated contact structure is arranged away from the first surface. The solar cell further includes: a first functional layer arranged on a side of the doped crystalline silicon layer away from the first surface; a second diffusion layer and a second functional layer sequentially stacked on the second surface of the silicon wafer, where one of the second diffusion layer and the doped crystalline silicon layer is a P+ type doped layer and the other of the second diffusion layer and the doped crystalline silicon layer is an N+ type doped layer; and a third functional layer located on the surface on which the P+ type doped layer is arranged, the third functional layer being arranged between the first functional layer and the doped crystalline silicon layer or the third functional layer being arranged between the second functional layer and the second diffusion layer.

Further, the solar cell further includes: a first electrode forming an ohmic contact with the doped crystalline silicon layer; and a second electrode forming an ohmic contact with the second diffusion layer.

In the structure of the above-mentioned solar cell, by arranging the passivated contact structure described in the first aspect on the first surface of the silicon wafer (i.e., the front surface of the silicon wafer), both the conductivity and the passivation effect of the solar cell can be effectively improved. One of the second diffusion layer and the doped crystalline silicon layer being the P+ type doped layer and the other of the second diffusion layer and the doped crystalline silicon layer being the N+ type doped layer includes two cases: firstly, when the second diffusion layer is the P+ type doped layer, the doped crystalline silicon layer is accordingly the N+ type doped layer; and secondly, when the second diffusion layer is the N+ type doped layer, the doped crystalline silicon layer is accordingly the P+ type doped layer. When the doped crystalline silicon layer is the P+ type doped layer, the third functional layer is arranged between the first functional layer and the doped crystalline silicon layer to provide corresponding passivation and protection for the P+ type doped layer. In this case, the first electrode penetrates through the first functional layer and the third functional layer to form the ohmic contact with the doped crystalline silicon layer, and the second electrode penetrates through the second functional layer to form the ohmic contact with the second diffusion layer. When the second diffusion layer is the P+ type doped layer, the third functional layer is arranged between the second functional layer and the second diffusion layer to provide corresponding passivation and protection for the P+ type doped layer. In this case, the first electrode penetrates through the first functional layer to form the ohmic contact with the doped crystalline silicon layer, and the second electrode penetrates through the second functional layer and the third functional layer to form the ohmic contact with the second diffusion layer.

As yet another optional embodiment, the passivated contact structure may be arranged on the two surfaces, and the first surface and the second surface of the silicon wafer are each provided with the passivated contact structure. In this embodiment, the passivated contact structure includes a first passivated contact structure arranged on the first surface of the silicon wafer and a second passivated contact structure arranged on the second surface of the silicon wafer. The first passivated contact structure includes a first passivation oxide layer and a first doped crystalline silicon layer, with the first passivation oxide layer arranged proximate to the first surface and the first doped crystalline silicon layer arranged away from the first surface. The second passivated contact structure includes a second passivation oxide layer and a second doped crystalline silicon layer, with the second passivation oxide layer arranged proximate to the second surface and the second doped crystalline silicon layer arranged away from the second surface. One of the first doped crystalline silicon layer and the second doped crystalline silicon layer is the P+ type doped layer, and the other of the first doped crystalline silicon layer and the second doped crystalline silicon layer is the N+ type doped layer.

The solar cell further includes: a first functional layer arranged on a side of the first doped crystalline silicon layer away from the first surface; a second functional layer arranged on a side of the second doped crystalline silicon layer away from the second surface; and a third functional layer located on the surface on which the P+ type doped layer is arranged. The third functional layer is arranged between the first functional layer and the first doped crystalline silicon layer, or the third functional layer is arranged between the second functional layer and the second doped crystalline silicon layer.

Further, the solar cell further includes: a first electrode forming an ohmic contact with the first doped crystalline silicon layer; and a second electrode that penetrates through the second passivation layer to form an ohmic contact with the second doped crystalline silicon layer.

In the structure of the above-mentioned solar cell, by arranging the passivated contact structure described in the first aspect on each of the first surface and the second surface of the silicon wafer (i.e., the front surface and the back surface of the silicon wafer), both the conductivity and the passivation effect of the solar cell can be effectively improved. One of the first doped crystalline silicon layer and the second doped crystalline silicon layer being the P+ type doped layer and the other of the first doped crystalline silicon layer and the second doped crystalline silicon layer being the N+ type doped layer includes two cases: firstly, when the first doped crystalline silicon layer is the P+ type doped layer, the second doped crystalline silicon layer is accordingly the N+ type doped layer; and secondly, when the first doped crystalline silicon layer is the N+ type doped layer, the second doped crystalline silicon layer is accordingly the P+ type doped layer. When the first doped crystalline silicon layer is the P+ type doped layer, the third functional layer is arranged between the first functional layer and the first doped crystalline silicon layer to provide corresponding passivation and protection for the P+ type doped layer. In this case, the first electrode penetrates through the first functional layer and the third functional layer to form the ohmic contact with the first doped crystalline silicon layer, and the second electrode penetrates through the second functional layer to form the ohmic contact with the second doped crystalline silicon layer. When the second doped crystalline silicon layer is the P+ type doped layer, the third functional layer is arranged between the second functional layer and the second doped crystalline silicon layer to provide corresponding passivation and protection for the P+ type doped layer. In this case, the first electrode penetrates through the first functional layer to form the ohmic contact with the doped crystalline silicon layer, and the second electrode penetrates through the second functional layer and the third functional layer to form the ohmic contact with the second diffusion layer.

Optionally, a diameter of the micropores is 50 nm to 500 nm. Optionally, a quantity of the micropores is 1×10⁴ pores/cm² to 1.6×10⁸ pores/cm². When the diameter and the quantity of the micropores are controlled within the above-mentioned ranges, on one hand, it is conducive to ensuring a good conductivity, and on the other hand, it is conducive to stabilizing the passivation effect, preventing excessive and oversized pores from adversely affecting the passivation effect, and avoiding excessively fine and insufficient pores from impacting the conductivity for the majority carriers, which may lead to an increase in series resistance of majority-carrier transport.

Further, the doped crystalline silicon layer is a fragmented crystalline silicon layer doped with a first element and a second element. The first element is phosphorus element or boron element. The second element is at least one of nitrogen element, carbon element, or oxygen element. In this way, the doping of the first element in the fragmented crystalline silicon layer can cause band bending, thereby prolonging the lifetime of minority carriers in this structure. When the phosphorus element is used as the first element, the diffusion of holes in the silicon wafer to the surface of the silicon wafer can be blocked, thereby reducing the probability of recombination between the metals and the holes on the surface. When the boron element is used as the first element, the diffusion of electrons in the silicon wafer to the surface of the silicon wafer is blocked, thereby reducing the probability of recombination between the metals and the electrons on the surface. Meanwhile, compared to polysilicon, the fragmented crystalline silicon has a larger number of crystalline grain boundaries, thereby facilitating the diffusion of the nitrogen element, the carbon element, or the oxygen element as the second element into the fragmented crystalline silicon layer. On the other hand, the doping and diffusion of the second element into the fragmented crystalline silicon layer broaden the band gap of the fragmented crystalline silicon layer, which helps reduce parasitic absorption and improve the photoelectric conversion efficiency of the solar cell.

Further, a concentration of the second element in the fragmented crystalline silicon layer is greater than 3%. A band gap of the fragmented crystalline silicon layer is at least 0.3 eV greater than that of the silicon wafer. When the doping concentration of the second element such as the nitrogen element, the carbon element, or the oxygen element in the fragmented crystalline silicon layer is greater than 3%, the improvement in the band gap of the fragmented crystalline silicon layer is more significant, and the band gap of the fragmented crystalline silicon layer is at least 0.3 eV greater than that of the silicon wafer and at least 0.15 eV greater than that of the polysilicon layer undoped with the second element.

Further, a thickness of the fragmented crystalline silicon layer is 40 nm to 200 nm. A size of a crystalline grain of the fragmented crystalline silicon layer is 30 nm to 100 nm. When the thickness and the grain size of the fragmented crystalline silicon layer are controlled within the above-mentioned ranges, it is conducive to a balance between the structural stability of the fragmented crystalline silicon layer, a difficulty level of doping of the first element and the second element, and the impact of optical absorption on the solar cell, thereby preventing silver paste from burning through the fragmented crystalline silicon layer when performing a fabrication process on the fragmented crystalline silicon layer, also avoiding excessive sunlight absorption that may influence the photoelectric conversion efficiency when the layer is too thick, and also promoting easier doping and diffusion of the first element and the second element into the fragmented crystalline silicon layer with an appropriate grain size.

Optionally, a morphology of the silicon wafer is a polished surface, a random pyramid textured surface, or an inverted pyramid textured surface. The first functional layer is a silicon nitride layer, a silicon oxynitride layer, or a silicon oxide layer. Optionally, the second functional layer is at least one of a silicon nitride layer, a silicon oxynitride layer, or a silicon oxide layer. Optionally, the third functional layer is an aluminum oxide layer.

Forming the "pyramid"-like textured surface on the surface of the silicon wafer can effectively enhance the absorption of incident sunlight by the silicon wafer and increase the photo-generated current density. Using the above-mentioned material layers as the first functional layer and the second functional layer of the silicon wafer can achieve good functions of light reflection reduction and passivation protection. When the third functional layer of the silicon wafer is the aluminum oxide layer, the surface on which the P+doped layer is located can be well protected, and a good passivation ability is achieved.

In a third aspect, embodiments of the present application further provide a preparation method for the solar cell described in the second aspect. The method includes the following steps:

Preparation of the passivated contact structure: forming a dielectric layer and an amorphous film layer on the first surface and/or the second surface of the silicon wafer, and subjecting the silicon wafer formed with the dielectric layer and the amorphous film layer to an annealing treatment to convert the dielectric layer into the passivation oxide layer and crystallize the amorphous film layer into the doped crystalline silicon layer, where a thickness of the passivation oxide layer is 1.5 nm to 3.5 nm, and a plurality of nanoscale micropores are formed in the passivation oxide layer.

In the embodiments of the present application, the dielectric layer and the amorphous film layer of certain thicknesses are first formed sequentially on the first surface and/or the second surface of the silicon wafer, and then subjected to the annealing treatment. On one hand, the high temperature in the annealing process induces the generation of a certain number and size of pinhole-shaped cracks in the dielectric layer, such that after the dielectric layer is converted into the passivation oxide layer, the passivation oxide layer not only can have a certain thickness to ensure the passivation effect, but also can be formed with the nanoscale micropores to improve the conductivity. On the other hand, the amorphous film layer is crystallized into the doped crystalline silicon layer through annealing, so that the passivation oxide layer and the doped crystalline silicon layer collectively form the passivated contact structure.

In the embodiments of the present application, in order to form the doped crystalline silicon layer with better performance, the structure and the performance of the doped crystalline silicon layer can be optimized by forming a plurality of amorphous film layers and doping different elements in the different amorphous film layers.

As an optional embodiment, the step of preparing the passivated contact structure includes:
sequentially depositing the dielectric layer, a first intrinsic layer doped with the second element, a first doped layer doped with the first element, and a mask layer on the silicon wafer, where the first intrinsic layer and the first doped layer are amorphous film layers; and
performing the annealing treatment after the deposition to cause the first intrinsic layer and the first doped layer to collectively form the doped crystalline silicon layer, where the doped crystalline silicon layer is a fragmented crystalline silicon layer doped with the first element and the second element, the first element is phosphorus element or boron element, and the second element is at least one of nitrogen element, carbon element, or oxygen element.

In the above embodiment, on basis of deposition of the dielectric layer, two amorphous film layers are sequentially deposited. The second element is doped into the first intrinsic layer while forming the first intrinsic layer, and the first element is doped into the first doped layer while forming the first doped layer. In this way, after the annealing treatment, not only the fragmented crystalline silicon layer doped with both the first element and the second element can be obtained, but also the issue of the first element being difficult to be successfully doped due to the doping of both the first element and the second element in the same film layer can be avoided.

Further, in the step of preparing the passivated contact structure, conditions for depositing the dielectric layer include: using a PECVD method, introducing N₂O at 8 SLM to 15 SLM, for a time of 80 s to 200 s.

Further, conditions for depositing the first intrinsic layer include: using the PECVD method, introducing SiH₄, H₂, and YₐO_{b} in a volume ratio of 1:(2 to 4):(0.1 to 1), for a deposition time of 20 s to 120 s, where Y in the YₐO_{b} is selected from carbon element, nitrogen element, or oxygen element, a is selected from 0, 1, 2, 3, or 4, and b is selected from 1, 2, 3, or 4.

Further, conditions for depositing the first doped layer include: using the PECVD method, introducing SiH₄, XₘHₙ, and H₂ in a volume ratio of 1:(0.5 to 1):(2 to 4), for a deposition time of 200 s to 600 s, where Y in the XₘHₙ is selected from phosphorous element or boron element, m is selected from 1 or 2, and n is selected from 3 or 6.

In the embodiments of the present application, the doping concentrations of the first element and the second element and the thickness of each layer are controlled by controlling conditions such as a ratio of introduced gases and the deposition time. Additionally, doping the second element into the first intrinsic layer, rather than into the first doped layer doped with the first element can prevent the situation where the first element fails to be successfully doped due to the easy reaction between YₐO_{b} and XₘHₓ.

Further, a thickness of the dielectric layer is1.5 nm to 3.5 nm.

Further, a thickness of the first intrinsic layer is 10 nm to 40 nm.

Further, a thickness of the first doped layer is 50 nm to 100 nm.

As another optional embodiment, the step of preparing the passivated contact structure includes:
sequentially depositing the dielectric layer, a first intrinsic layer, a first doped layer doped with a first element, a second intrinsic layer doped with a second element, a second doped layer doped with the first element, and a mask layer on the silicon wafer, where the first intrinsic layer, the first doped layer, the second intrinsic layer, and the second doped layer are amorphous film layers; and
performing the annealing treatment after deposition to cause the first intrinsic layer, the first doped layer, the second intrinsic layer, and the second doped layer to collectively form the doped crystalline silicon layer, where the doped crystalline silicon layer is a fragmented crystalline silicon layer doped with the first element and the second element, the first element is phosphorus element or boron element, and the second element is at least one of nitrogen element, carbon element, or oxygen element.

In the embodiments of the present application, to form a doped crystalline silicon layer with better performance, on the basis of the deposition of the dielectric layer, four amorphous film layers are sequentially deposited. The second element is selected to be doped into the second intrinsic layer. On one hand, since the second intrinsic layer is a layer away from the dielectric layer, the second element can be successfully doped while avoiding any impact on the dielectric layer. On the other hand, because the second element and the first element are not doped in the same film layer, the issue of the first element being difficult to be successfully doped due to the deposition of the second element in the same film layer can be avoided. Doping the first element in each of the first doped layer and the second doped layer which are different can allow for more uniform doping and diffusion of the first element such as the phosphorus element throughout the doped crystalline silicon layer during subsequent annealing.

Further, conditions for depositing the dielectric layer include: using the PECVD method, introducing N₂O at 8 SLM to 15 SLM, for a time of 80 s to 200 s.

Further, conditions for depositing the first intrinsic layer include: using the PECVD method, and introducing SiH₄ and H₂ in a volume ratio of 1:(2 to 4), for a deposition time of 20 s to 120 s.

Further, conditions for depositing the first doped layer include: using the PECVD method, and introducing SiH₄, XₘHₙ, and H₂ in a volume ratio of 1:(0.5 to 1):(2 to 4), for a deposition time of 200 s to 350 s, where X in the XₘHₙ is selected from phosphorous element or boron element, m is selected from 1 or 2, and n is selected from 3 or 6.

Further, conditions for depositing the second intrinsic layer include: using the PECVD method, introducing SiH₄, H₂, and YₐO_{b} in a volume ratio of 1:(2 to 4):(0.1 to 1), for a deposition time of 20 s to 120 s, where Y in the YₐO_{b} is selected from carbon element, nitrogen element, or oxygen element, a is selected from 0, 1, 2, 3, or 4, and b is selected from 1, 2, 3, or 4. In some embodiments, for example, the YₐO_{b} may be CO₂ to dope the carbon element and the oxygen element into the fragmented crystalline silicon layer; and in some other embodiments, the YₐO_{b} may be N₂O to dope the nitrogen element and the oxygen element into the fragmented crystalline silicon layer.

Further, conditions for depositing the second doped layer include: using the PECVD method, introducing SiH₄, XₘHₙ, and H₂ in a volume ratio of 1:(0.5 to 1):(2 to 4), for a deposition time of 200 s to 350 s, where X in the XₘHₙ is selected from the phosphorous element or the boron element, m is selected from 1 or 2, and n is selected from 3 or 6.

In the embodiments of the present application, the doping concentrations of the first element and the second element and the thickness of each layer are controlled by controlling conditions such as a ratio of introduced gases and the deposition time. Additionally, doping the second element into the second intrinsic layer, rather than into the first doped layer or the second doped layer can prevent the situation where the first element fails to be successfully doped due to the easy reaction between the YₐO_{b} and the XₘHₙ.

Further, a thickness of the dielectric layer is1.5 nm to 3.5 nm.

Further, a thickness of the first intrinsic layer is 5 nm to 40 nm.

Further, a thickness of the first doped layer is 20 nm to 60 nm.

Further, a thickness of the second intrinsic layer is 5 nm to 40 nm.

Further, a thickness of the second doped layer is 20 nm to 60 nm.

Further, in the step of preparing the passivated contact structure, a deposition temperature for the dielectric layer and the amorphous film layer is 350°C to 500°C, a deposition time is 30 min to 60 min, an annealing temperature is 930°C to 1050°C, and an annealing time is 50 min to 170 min.

Through the control of the above-mentioned process conditions, after depositing the corresponding film layers, a single high-temperature annealing can both create nanoscale pinhole-like ruptures on the dielectric layer, forming the plurality of micropores that can form the conducting channels, and crystallize the deposited amorphous film layer into the fragmented crystalline silicon layer with finer crystalline grains and more crystalline grain boundaries. The crystallization characteristic of the fragmented crystalline silicon layer is utilized for doping of more second elements, thereby broadening the band gap of the fragmented crystalline silicon layer, reducing the parasitic absorption, and improving the photoelectric conversion efficiency.

Exemplarily, the deposition temperature for the dielectric layer and the amorphous film layer being 350°C to 500°C includes any point value within this temperature range. For example, the deposition temperature for the dielectric layer and the amorphous film layer is 350°C, 360°C, 380°C, 400°C, 410°C, 430°C, or 450°C. The deposition time being 30 min to 60 min includes any point value within this time range. For example, the deposition time is 30 min, 40 min, 45 min, 50 min, or 60 min. The annealing temperature being 930°C to 1050°C includes any point value within this temperature range. For example, the annealing temperature is 930°C, 940°C, 950°C, 960°C, 970°C, 980°C, 1000°C, 1020°C, or 1050°C. The annealing time being 50 min to 170 min includes any point value within this time range. For example, the annealing time is 80 min, 90 min, 100 min, 120 min, 150 min, or 170 min.

It should be understood that, in addition to the step of preparing the passivated contact structure, the preparation method for the solar cell in the embodiments of the present application may also include other steps, such as pre-treatment steps such as texturing the silicon wafer before preparing the passivated contact structure, and/or post-treatment steps such as removing substances wrapped around the silicon wafer after preparing the passivated contact structure, as well as depositing other functional layers and preparing electrodes. Specific details will be introduced later.

In an optional embodiment, in addition to the step of preparing the passivated contact structure, before this step, the preparation method in the present application also includes a step of pre-depositing a dielectric layer. The pre-deposition step involves pre-depositing a dielectric layer through a wet process. Specifically, the pre-deposition step involves pre-depositing a dielectric layer with a thickness of 0.3 nm to 0.7 nm on the silicon wafer through a wet process for a pre-deposition time of 2 min to 5 min.

A thinner dielectric layer is firstly pre-deposited through the wet deposition process to obtain a denser dielectric layer. Then, on this basis, a thicker dielectric layer continues to be deposited through the PECVD method in the step of preparing the passivated contact structure, thereby combining the advantages of wet deposition and PECVD deposition to obtain a dielectric layer that is both dense and meets thickness requirements, and thus allowing the subsequently annealed passivation oxide layer to have a higher density and further improving the passivation effect on the interface of the silicon wafer.

Additionally, since the silicon wafer in the embodiments of the present application is provided with the first surface and the second surface opposite to each other, and the passivated contact structure may be arranged on the first surface or the second surface, or both the first surface and the second surface, the solar cell in the embodiments of the present application may have multiple structures.

As an optional embodiment, the passivated contact structure may be arranged only on the second surface of the silicon wafer. In this embodiment, the step of preparing the passivated contact structure involves forming the dielectric layer and the amorphous film layer sequentially on the second surface of the silicon wafer, followed by the annealing treatment to form the passivation oxide layer proximate to the second surface and the doped crystalline silicon layer away from the second surface.

The preparation method further includes a pre-treatment step before the step of preparing the passivated contact structure. The pre-treatment step involves preparing a first diffusion layer on the first surface of the silicon wafer. One of the first diffusion layer and the doped crystalline silicon layer is a P+ type doped layer, and the other of the first diffusion layer and the doped crystalline silicon layer is an N+ type doped layer.

Further, the preparation method also includes a post-treatment step after the step of preparing the passivated contact structure. The post-treatment step involves forming a first functional layer on the first diffusion layer and a second functional layer on the doped crystalline silicon layer; forming a third functional layer on the surface on which the P+ type doped layer is arranged, with the third functional layer arranged between the first functional layer and the first diffusion layer or between the second functional layer and the doped crystalline silicon layer; and forming a first electrode in an ohmic contact with the first diffusion layer and a second electrode in an ohmic contact with the doped crystalline silicon layer.

In the above preparation method, the first diffusion layer is first prepared on the first surface of the silicon wafer (i.e., the front surface of the silicon wafer), and then the passivation oxide layer and the doped crystalline silicon layer are prepared on the second surface of the silicon wafer (i.e., the back surface of the silicon wafer), with the passivated contact structure formed by these two layers form. Subsequently, on this basis, the first functional layer is formed on the first diffusion layer on the first surface of the silicon wafer, the second functional layer is formed on the doped crystalline silicon layer on the second surface of the silicon wafer, the third functional layer is also arranged on the surface on which the P+ type doped layer is formed, and the first electrode and the second electrode are prepared, thereby completing the preparation of the solar cell. In this way, since the second surface of the silicon wafer is provided with the passivated contact structure described in the first aspect above, the performance enhancement in both the conductive property and the passivation ability of the solar cell can be achieved.

Additionally, the first functional layer and the second functional layer may also be utilized to provide corresponding functional protection for the front surface and the back surface of the silicon wafer, while the third functional layer, being arranged on an inner side of the first functional layer or the second functional layer, is utilized to provide further functional protection for the surface on which the P+ type doped layer is located.

If the first diffusion layer is the P+ type doped layer, for example, if the first diffusion layer is a film layer doped with boron through boron diffusion, namely a P+ type doped layer, then the first element doped in the doped crystalline silicon layer may be phosphorus element, forming the N+ type doped layer. In this case, the third functional layer is arranged between the first functional layer and the first diffusion layer to provide corresponding passivation and protection for the P+ type doped layer. The first electrode penetrates through the first functional layer and the third functional layer to form the ohmic contact with the first diffusion layer, and the second electrode penetrates through the second functional layer to form the ohmic contact with the doped crystalline silicon layer. If the doped crystalline silicon layer is the P+ type doped layer, for example, if the first element doped in the doped crystalline silicon layer is boron element, namely the P+ type doped layer, then the first diffusion layer may be formed as a phosphorus-doped film layer, forming the N+ type doped layer. In this case, the third functional layer is arranged between the second functional layer and the doped crystalline silicon layer to provide corresponding passivation and protection for the P+ type doped layer. The first electrode penetrates through the first functional layer to form the ohmic contact with the first diffusion layer, and the second electrode penetrates through the second functional layer and the third functional layer to form the ohmic contact with the doped crystalline silicon layer.

Taking the first diffusion layer being the P+ type doped layer and the first element doped in the doped crystalline silicon layer being the phosphorous element to form the N+ type doped layer as an example, the pre-treatment step and the post-treatment step of the preparation method are further described below.

In the above embodiment, the pre-treatment step includes:
providing a textured silicon wafer;
subjecting the silicon wafer to boron diffusion and junction pushing to form the diffusion layer; and
removing a substance wrapped around the second surface of the silicon wafer in the boron diffusion.

When the pre-deposition step is performed before the step of preparing the passivated contact structure, the pre-deposition is performed after the step of removing the substance wrapped around the second surface of the silicon wafer in the boron diffusion, to firstly deposit a thin but dense dielectric layer, and then the passivated contact structure is prepared through deposition methods such as the PECVD.

Additionally, it should be noted that the silicon wafer processed through a plurality of procedures such as slicing, grinding, chamfering, and polishing have adsorbed various impurities on its surface, such as granules, metal particles, silicon powder dust, and organic impurities, and cleaning is required before diffusion to remove various contaminants and mechanical damaged layer, and a cleanliness level after cleaning directly affects a yield and a reliability rate of solar cell pieces. In some embodiments, in the step of providing the textured silicon wafer, a rapid texturing is performed using sodium hydroxide and an additive of model TS40 in a volume ratio of 7:1 at 80°C for 7 min, and a thinning amount is controlled to 5 µm. In this way, the silicon wafer can be textured and cleaned to obtain a uniform pyramid-like textured structure that facilitates light absorption by the solar cell, thereby improving the conversion efficiency of the solar cell.

In some embodiments, the step of subjecting the silicon wafer to boron diffusion and junction pushing to form the diffusion layer involves placing the textured silicon wafer into a boron diffusion furnace, depositing a boron source at the temperature of 800°C to 850°C using a boron source gas and oxygen gas in a volume ratio of 1:(2 to 4), and then pushing the boron source at 950°C to 1050°C for 0.8 h to 1.2 h to form a diffusion region, i.e., to form a P-N junction, with the sheet resistance after diffusion controlled at 120 Q/sq to 140 Q/sq. The textured silicon wafer enters the boron diffusion furnace to be subjected to the boron diffusion and junction pushing. A vapor of the boron source is reacted with O₂ within a lower temperature range (800°C to 850°C) to achieve the deposition of the boron source. Subsequently, the temperature is raised to a temperature for the boron diffusion and junction pushing of 950°C to 1050°C to allow boron to be diffused into the silicon wafer and to push the doped region forming the P-N junction.

Exemplarily, the temperature of the deposition of the boron source being 800°C to 850°C includes any point value within this temperature range, for example, the temperature of the deposition of the boron source is 800°C, 810°C, 820°C, 830°C, 840°C, or 850°C. The temperature of the boron diffusion and junction pushing being 950°C to 1050°C includes any point value within this temperature range, for example, the temperature of the boron diffusion and junction pushing is 950°C, 970°C, 990°C, 10 10°C, 1040°C, or 1050°C. The time of the boron diffusion and junction pushing being 0.8 h to 1.2 h includes any point value within this time range, for example, the time of the boron diffusion and junction pushing is 0.8 h, 0.9 h, 1 h, 1.1 h, or 1.2 h. The boron source gas may be only BCl₃ (boron trichloride) vapor or BBr₃ (boron tribromide) vapor, or a mixed gas of both, which is not specifically limited in this embodiment. It should be understood that the boron tribromide vapor has a lower cost, while the boron trichloride vapor has a better diffusion uniformity, and the byproducts of the boron trichloride cause minimal damage to quartz devices.

After the boron diffusion and junction pushing, the second surface of the silicon wafer may have substances such as borosilicate glass formed and wrapped around thereon due to the boron diffusion and P-N junction wrapped around the second surface and edges. Therefore, there is a need to remove the substances wrapped around the second surface of the silicon wafer in the boron diffusion. Specifically, the borosilicate glass wrapped around the second surface of the silicon wafer in the boron diffusion is firstly removed with a hydrofluoric acid solution with a volume percentage of 40% to 60% through a chain-type HF machine. Subsequently, the silicon wafer is transferred by a robotic arm to a tank-type alkaline polishing machine, and is polished with sodium hydroxide and an alkaline polishing additive BP31 in a volume ratio of 3:(0.5 to 2) at 70°C to 90°C for 5 min to 10 min, to remove the P-N junction wrapped around the second surface and edges in the boron diffusion.

Exemplarily, the volume percentage of the hydrofluoric acid solution being 40% to 60% includes any point value within this numerical range, for example, the volume percentage of the hydrofluoric acid solution is 40%, 45%, 50%, 55%, or 60%. A volume ratio of sodium hydroxide to the alkaline polishing additive BP31 being 3:(0.5 to 2) includes any point value within this ratio range, for example, the volume ratio of sodium hydroxide to the alkaline polishing additive BP31 is 3:0.5, 3:0.8, 3:1, 3:1.5, or 3:2. The polishing treatment temperature being 70°C to 90°C includes any point value within this temperature range, for example, the polishing treatment temperature is 70°C, 72°C, 75°C, 78°C, or 80°C. The polishing treatment time being 5 min to 10 min includes any point value within this time range, for example, the polishing treatment time is 5 min, 6 min, 7 min, 8 min, 9 min, or 10 min.

After removing the above-mentioned substances wrapped around the second surface of the silicon wafer due to boron diffusion treatment, a thinner dielectric layer may be firstly pre-deposited through the wet process. Although this layer is thinner and cannot directly meet the thickness requirement of the passivation oxide layer in the embodiments of the present application, the dielectric layer may serve as a pre-deposition layer to provide a denser film structure, laying a certain foundation for the subsequent deposition of a thicker dielectric layer using the PECVD method. Specifically, the alkali-polished silicon wafer may be placed in a tank containing a sodium hydroxide solution with a mass concentration of 3% to 5% and hydrogen peroxide and subjected to the wet deposition for 2 min to 5 min to grow a dielectric layer with a thickness of 0.4 nm to 0.6 nm.

Further, in the above embodiment, the post-treatment step includes:
removing substances deposited and wrapped around the first surface of the silicon wafer;
depositing the third functional layer and the first functional layer on the first diffusion layer on the first surface of the silicon wafer;
depositing the second functional layer on the doped crystalline silicon layer on the second surface of the silicon wafer; and
fabricating the first electrode and the second electrode.

Since the annealed silicon wafer has the substances such as the dielectric layer and the doped crystalline silicon layer wrapped around its first surface, there is a need to remove the substances deposited and wrapped around the first surface of the silicon wafer. Specifically, the dielectric layer on the first surface of the silicon wafer is firstly removed with a hydrofluoric acid solution with a mass concentration of 3% to 7% through a chain-type HF machine. Subsequently, the silicon wafer is transferred by a robotic arm into a tank-type alkaline polishing machine and is polished with sodium hydroxide and an alkaline polishing additive BP31 in a volume ratio of 2:(0.5 to 2) at 70°C to 90°C for 1 min to 3 min to remove the doped crystalline silicon layer wrapped around the first surface due to the boron diffusion. Thereafter, the silicon wafer is transferred into an acid tank to remove the borosilicate glass layer on the first surface and the mask layer on the second surface with a hydrofluoric acid solution with a mass concentration of 3% to 7%.

Continuing further, an aluminum oxide film layer as the third functional layer for passivation is deposited on the first surface of the silicon wafer through an atomic layer deposition (ALD) device, with a deposition thickness being 3 nm to 7 nm. Then, a silicon nitride film, a silicon oxynitride film, and a silicon oxide film, as the first functional layer for anti-reflection, is sequentially deposited on the first surface of the silicon wafer through a plasma enhanced chemical vapor deposition (PECVD) device, with a total thickness of the first functional layer being 75 nm to 85 nm and a refractive index of the first functional layer being 1.95 to 2.00. Subsequently, a silicon nitride film as the second functional layer for back-film hydrogen passivation is deposited on the second surface of the silicon wafer through the PECVD device, with a thickness of the second functional layer being 75 nm to 80 nm and a refractive index of the second functional layer being 2.10 to 2.15.

Exemplarily, the thickness of the third functional layer being 3 nm to 7 nm includes any point value within this thickness range. For example, the thickness of the third functional layer is 3 nm, 4 nm, 5 nm, 6 nm, or 7 nm. Exemplarily, the deposition thickness of the first functional layer being 75 nm to 85 nm includes any point value within this deposition thickness range. For example, the deposition thickness of the first functional layer is 75 nm, 77 nm, 80 nm, 82 nm, or 85 nm. The deposition thickness of the second functional layer being 75 nm to 85 nm includes any point value within this deposition thickness range. For example, the deposition thickness of the second functional layer is 75 nm, 77 nm, 80 nm, 82 nm, or 85 nm.

Finally, a silver-aluminum paste is printed on the first surface of the silicon wafer and a silver paste is printed on the second surface of the silicon wafer by screen printing, and the silicon wafer is sintered at 800°C to 850°C to fabricate the first electrode and the second electrode. Subsequently, the cell is subjected to optical injection at 650°C to 750°C.

It should be understood that in this embodiment, the first electrode may alternatively be obtained by printing the silver paste, and the second electrode may alternatively be obtained by printing the silver-aluminum paste. When the first diffusion layer is the N+ type doped layer and the first element doped in the doped crystalline silicon layer is boron element to form the P+ type doped layer, the first electrode and the second electrode may be respectively obtained by printing the silver paste on the first surface of the silicon wafer and printing the silver-aluminum paste on the second surface of the silicon wafer, followed by sintering.

As another optional embodiment, the passivated contact structure may be arranged only on the first surface of the silicon wafer. In this embodiment, the step of preparing the passivated contact structure involves forming the dielectric layer and the amorphous film layer sequentially on the first surface of the silicon wafer, followed by the annealing treatment, to form the passivation oxide layer proximate to the first surface and the doped crystalline silicon layer away from the first surface.

Further, the preparation method also includes a post-treatment step after the step of preparing the passivated contact structure. The post-treatment step involves preparing a second diffusion layer on the second surface of the silicon wafer, where one of the second diffusion layer and the doped crystalline silicon layer is a P+ type doped layer, and the other of the second diffusion layer and the doped crystalline silicon layer is an N+ type doped layer; forming a first functional layer on the doped crystalline silicon layer and forming a second functional layer on the second diffusion layer; forming a third functional layer on the surface on which the P+ type doped layer is arranged, with the third functional layer arranged between the first functional layer and the doped crystalline silicon layer, or with the third functional layer arranged between the second functional layer and the second diffusion layer; and forming a first electrode in an ohmic contact with the doped crystalline silicon layer and a second electrode in an ohmic contact with the second diffusion layer.

In the above preparation method, the passivation oxide layer and the doped crystalline silicon layer are firstly prepared on the first surface of the silicon wafer (i.e., the front surface of the silicon wafer), with the passivated contact structure formed by these two layers, and then the second diffusion layer is prepared on the second surface of the silicon wafer (i.e., the back surface of the silicon wafer). Subsequently, on this basis, the first functional layer is formed on the doped crystalline silicon layer on the first surface of the silicon wafer, the second functional layer is formed on the second diffusion layer on the second surface of the silicon wafer, the third functional layer is also provided on the surface on which the P+ type doped layer is formed, and the first electrode and the second electrode are prepared, thereby completing the preparation of the solar cell. In this way, since the first surface of the silicon wafer is provided with the passivated contact structure described in the first aspect above, the performance enhancement in both the conductive property and the passivation ability of the solar cell can be achieved.

Additionally, the first functional layer and the second functional layer may also be utilized to provide corresponding functional protection for the front surface and the back surface of the silicon wafer, while the third functional layer, being arranged on the inner side of the first functional layer or the second functional layer, is utilized to provide further functional protection for the surface on which the P+ type doped layer is located.

When the doped crystalline silicon layer is the P+ type doped layer (e.g., the first element doped in the doped crystalline silicon layer is boron element), the second diffusion layer may be a phosphorus-doped film layer, forming the N+ type doped layer. In this case, the third functional layer is arranged between the first functional layer and the doped crystalline silicon layer to providing corresponding protection for the P+ type doped layer. The first electrode penetrates through the first functional layer and the third functional layer to form the ohmic contact with the doped crystalline silicon layer, and the second electrode penetrates through the second functional layer to form the ohmic contact with the second diffusion layer.

When the second diffusion layer is the P+ type doped layer, for example, the second diffusion layer is a boron-doped film layer obtained through boron diffusion, namely the P+ type doped layer, the first element doped in the doped crystalline silicon layer may be phosphorus element, forming the N+ type doped layer. In this case, the third functional layer is arranged between the second functional layer and the second diffusion layer to provide corresponding protection for the P+ type doped layer. The first electrode penetrates through the first functional layer to form the ohmic contact with the doped crystalline silicon layer, and the second electrode penetrates through the second functional layer and the third functional layer to form the ohmic contact with the second diffusion layer.

Taking the first element doped in the doped crystalline silicon layer being boron element to form the P+ type doped layer and the second diffusion layer being the N+ type doped layer as an example, the pre-treatment step and the post-treatment step of the preparation method are further described below.

In the above embodiment, the preparation method for the solar cell further includes a pre-treatment step before the step of preparing the passivated contact structure. The pre-treatment step includes: providing a textured silicon wafer. The silicon wafer processed through a plurality of procedures such as slicing, grinding, chamfering, and polishing have adsorbed various impurities on its surface, such as granules, metal particles, silicon powder dust, and organic impurities, and cleaning is required before diffusion to remove various contaminants and any mechanical damaged layer, and a cleanliness level after cleaning directly affects the yield and the reliability rate of the solar cell pieces. In some embodiments, in the step of providing the textured silicon wafer, a rapid texturing is performed using sodium hydroxide and an additive of model TS40 in a volume ratio of 7:1 at 80°C for 7 min, with the thinning amount controlled to 5 µm. In this way, the silicon wafer can be textured and cleaned to obtain a uniform pyramid-like textured structure that facilitates light absorption by the solar cell, thereby improving the conversion efficiency of the solar cell.

When the pre-deposition step is performed before the step of preparing the passivated contact structure, the pre-deposition is performed after the step of texturing the silicon wafer to firstly deposit a thin but dense dielectric layer. Subsequently, the dielectric layer and the amorphous film layer are prepared using the deposition method such as PECVD and then subjected to the annealing treatment to form the passivation oxide layer and the doped crystalline silicon layer, with the passivated contact structure formed by these two layers.

Further, in the above embodiment, the post-treatment step includes:
removing substances deposited and wrapped around the second surface of the silicon wafer;
forming the second diffusion layer on the second surface of the silicon wafer;
removing substances wrapped around the first surface of the silicon wafer;
sequentially depositing the third functional layer and the first functional layer on the doped crystalline silicon layer on the first surface of the silicon wafer;
depositing the second functional layer on the second diffusion layer on the second surface of the silicon wafer; and
fabricating the first electrode and the second electrode.

Since the annealed silicon wafer has substances such as the dielectric layer and the doped crystalline silicon layer wrapped around the second surface, there is a need to remove the substances deposited and wrapped around the second surface of the silicon wafer. Specifically, the dielectric layer on the second surface of the silicon wafer is firstly removed with a hydrofluoric acid solution with a mass concentration of 3% to 7% using a chain-type HF machine. Subsequently, the silicon wafer is transferred by a robotic arm into a tank-type alkaline polishing machine and is polished with sodium hydroxide and an alkaline polishing additive BP31 in a volume ratio of 2:(0.5 to 2) at 70°C to 90°C for 1 min to 3 min, to remove the passivated contact structure wrapped around the second surface and edges in the boron diffusion.

After treating the second surface of the silicon wafer, phosphorous diffusion may be performed to form the second diffusion layer. It should be understood that in addition to performing phosphorus diffusion on the second surface of the silicon wafer to form the second diffusion layer across the entire surface, other methods may be used to achieve phosphorus diffusion. For example, the second diffusion layer can be also formed by localized phosphorus diffusion at a bottom of the second electrode.

Since the silicon wafer has substances wrapped around the first surface after the phosphorous diffusion, the substances wrapped around the first surface of the silicon wafer may be removed through acid washing with hydrofluoric acid and/or alkali washing with an alkaline solution.

Continuing further, an aluminum oxide film layer as the third functional layer for passivation is deposited on the first surface of the silicon wafer through an atomic layer deposition (ALD) device, with a deposition thickness being 3 nm to 7 nm. Then, a silicon nitride film, a silicon oxynitride film, and a silicon oxide film, as the first functional layer for anti-reflection, is sequentially deposited on the first surface of the silicon wafer through a plasma enhanced chemical vapor deposition (PECVD) device, with a total thickness of the first functional layer being 75 nm to 85 nm and a refractive index of the first functional layer being 1.95 to 2.00. Subsequently, a silicon nitride film as the second functional layer for back-film hydrogen passivation is deposited on the second surface of the silicon wafer through the PECVD device, with a thickness of the second functional layer being 75 nm to 80 nm and a refractive index of the second functional layer being 2.10 to 2.15.

Finally, a silver-aluminum paste is printed on the first surface of the silicon wafer and a silver paste is printed on the second surface of the silicon wafer by screen printing, and the silicon wafer is sintered at 800°C to 850°C to fabricate the first electrode and the second electrode. Subsequently, the cell is subjected to optical injection at 650°C to 750°C.

It should be understood that in this embodiment, the first electrode may alternatively be obtained by printing the silver paste, and the second electrode may alternatively be obtained by printing the silver-aluminum paste. When the doped crystalline silicon layer is the N+ type doped layer and the second diffusion layer is the P+ type doped layer, the first electrode and the second electrode may be respectively obtained by printing the silver paste on the first surface of the silicon wafer and printing the silver-aluminum paste on the second surface of the silicon wafer, followed by sintering.

As another optional embodiment, the passivated contact structure may be arranged on each of the first surface and the second surface of the silicon wafer, meaning that the passivated contact structure includes a first passivated contact structure arranged on the first surface of the silicon wafer and a second passivated contact structure arranged on the second surface of the silicon wafer. In this embodiment, the step of preparing the passivated contact structure includes: forming the dielectric layer and the amorphous film layer on each of the first surface and the second surface of the silicon wafer followed by annealing treatment to form the first passivated contact structure arranged on the first surface and the second passivated contact structure located on the second surface. The first passivated contact structure includes a first passivation oxide layer proximate to the first surface and a first doped crystalline silicon layer away from the first surface. The second passivated contact structure includes a second passivation oxide layer proximate to the second surface and a second doped crystalline silicon layer away from the second surface. One of the first doped crystalline silicon layer and the second doped crystalline silicon layer is the P+ type doped layer, and the other of the first doped crystalline silicon layer and the second doped crystalline silicon layer is the N+ type doped layer.

The preparation method further includes a post-treatment step after the step of preparing the passivated contact structure. The post-treatment step involves forming a first functional layer on the first doped crystalline silicon layer and a second functional layer on the second doped crystalline silicon layer; forming a third functional layer on the surface on which the P+ type doped layer is arranged, with the third functional layer arranged between the first functional layer and the first doped crystalline silicon layer or with the third functional layer arranged between the second functional layer and the second doped crystalline silicon layer; and forming a first electrode in an ohmic contact with the first doped crystalline silicon layer and a second electrode in an ohmic contact with the second doped crystalline silicon layer.

In the above preparation method, the first passivated contact structure and the second passivated contact structure are respectively prepared on the first surface and the second surface of the silicon wafer. Then, on this basis, the first functional layer is formed on the first doped crystalline silicon layer on the first surface of the silicon wafer, the second functional layer is formed on the second doped crystalline silicon layer on the second surface of the silicon wafer, the third functional layer is also arranged on the surface on which the P+ type doped layer is formed, and the first electrode and the second electrode are prepared, thereby completing the preparation of the solar cell. In this way, since both the first surface and the second surface of the silicon wafer are provided with the passivated contact structure described in the first aspect above, the performance enhancement in both the conductive property and the passivation ability of the solar cell can be achieved.

Additionally, the first functional layer and the second functional layer may also be utilized to provide corresponding functional protection for the front surface and the back surface of the silicon wafer, while the third functional layer, being arranged on the inner side of the first functional layer or the second functional layer, is utilized to provide further functional protection for the surface on which the P+ type doped layer is located.

When the first doped crystalline silicon layer is the P+ type doped layer (e.g., the first element doped in the first doped crystalline silicon layer is boron element), the second doped crystalline silicon layer is the N+ type doped layer (i.e., the first element doped in the second doped crystalline silicon layer is phosphorus element). In this case, the third functional layer is arranged between the first functional layer and the first doped crystalline silicon layer to provide corresponding passivation and protection for the P+ type doped layer. The first electrode penetrates through the first functional layer and the third functional layer to form the ohmic contact with the first doped crystalline silicon layer, and the second electrode penetrates through the second functional layer to form the ohmic contact with the second doped crystalline silicon layer.

When the second doped crystalline silicon layer is the P+ type doped layer (e.g., the first element doped in the second doped crystalline silicon layer is boron element), the first element doped in the first doped crystalline silicon layer may be phosphorous element to form the N+ type doped layer. In this case, the third functional layer is arranged between the second functional layer and the second doped crystalline silicon layer to provide corresponding passivation and protection for the P+ type doped layer. The first electrode penetrates through the first functional layer to form the ohmic contact with the first doped crystalline silicon layer, and the second electrode penetrates through the second functional layer and the third functional layer to form the ohmic contact with the second diffusion layer.

Taking the first doped crystalline silicon layer being the N+ type doped layer and the second doped crystalline silicon layer being the P+ type doped layer as an example, the pre-treatment step and the post-treatment step of the preparation method are further described below.

Further, in the above embodiment, the preparation method for the solar cell further includes a pre-treatment step before the step of preparing the passivated contact structure. The pre-treatment step includes: providing a textured silicon wafer. The silicon wafer processed through a plurality of procedures such as slicing, grinding, chamfering, and polishing have adsorbed various impurities on its surface, such as granules, metal particles, silicon powder dust, and organic impurities, and cleaning is required before diffusion to remove various contaminants and any mechanical damaged layer, and a cleanliness level after cleaning directly affects the yield and the reliability rate of the solar cell pieces. In some embodiments, in the step of providing the textured silicon wafer, a rapid texturing is performed using sodium hydroxide and an additive of model TS40 in a volume ratio of 7:1 at 80°C for 7 min, with the thinning amount controlled to 5 µm. In this way, the silicon wafer can be textured and cleaned to obtain a uniform pyramid-like textured structure that facilitates light absorption by the solar cell, thereby improving the conversion efficiency of the solar cell.

When the pre-deposition step is performed before the step of preparing the passivated contact structure, the pre-deposition is performed after the step of texturing the silicon wafer to firstly deposit a thin but dense dielectric layer. Subsequently, the dielectric layer and the amorphous film layer are prepared using the deposition method such as PECVD and then subjected to the annealing treatment to form the passivation oxide layer and the doped crystalline silicon layer, with the passivated contact structure formed by these two layers.

Additionally, since the first passivated contact structure and the second passivated contact structure are respectively prepared on the first surface and the second surface of the silicon wafer, in this implementation, the step of preparing the passivated contact structure includes:
forming the dielectric layer and the amorphous film layer on the first surface of the silicon wafer;
removing substances wrapped around the silicon wafer;
forming the dielectric layer and the amorphous film layer on the second surface of the silicon wafer; and
performing annealing treatment to convert the dielectric layer and the amorphous film layer on the first surface respectively into the first passivation oxide layer and the first doped crystalline silicon layer, and convert the dielectric layer and the amorphous film layer on the second surface respectively into the second passivation oxide layer and the second doped crystalline silicon layer.

In this way, only through single annealing, the first passivated contact structure and the second passivated contact structure can be prepared respectively on the two surfaces of the silicon wafer, thereby optimizing process steps and achieving energy conservation.

Further, to optimize the arrangement of the dielectric layer, a wet pre-deposition of the dielectric layer may be performed either before forming the dielectric layer on the first surface or before forming the dielectric layer on the second surface. Alternatively, the wet pre-deposition of the dielectric layer may be performed twice, meaning that before each deposition of the dielectric layer on the silicon wafer using a method such as PECVD, the wet pre-deposition of the dielectric layer is firstly performed. In this way, the advantages of wet deposition and PECVD deposition are combined, enabling the dielectric layer to have advantages of being dense and meeting thickness requirements.

Further, in the above embodiment, the post-treatment step includes:
removing substances deposited and wrapped around the silicon wafer;
depositing a first functional layer on the first doped crystalline silicon layer on the first surface of the silicon wafer;
sequentially depositing a third functional layer and a second functional layer on the second doped crystalline silicon layer on the second surface of the silicon wafer; and
fabricating the first electrode and the second electrode.

Since the annealed silicon wafer has the substances such as the mask layer and the doped crystalline silicon layer wrapped around the first surface and the second surface, there is a need to remove the wrapped substances due to deposition. Specifically, the mask layer on the first surface of the silicon wafer is firstly removed with a hydrofluoric acid solution with a mass concentration of 3% to 7% through a chain-type HF machine. Subsequently, the silicon wafer is transferred by a robotic arm into a tank-type alkaline polishing machine and is polished with sodium hydroxide and an alkaline polishing additive BP31 in a volume ratio of 2:(0.5 to 2) at 70°C to 90°C for 1 min to 3 min to remove the doped crystalline silicon layer wrapped around the first surface in the boron diffusion. Finally, the silicon wafer is transferred into an acid tank to remove the mask layer on the first surface and the second surface with a hydrofluoric acid solution with a mass concentration of 3% to 7%.

Continuing further, an aluminum oxide film layer as the third functional layer for passivation is deposited on the second surface of the silicon wafer through an atomic layer deposition (ALD) device, with a deposition thickness being 3 nm to 7 nm. Then, a silicon nitride film as the second functional layer for protection is deposited on the second surface of the silicon wafer through a plasma enhanced chemical vapor deposition (PECVD) device, with a thickness of the second functional layer being 75 nm to 80 nm and a refractive index of the second functional layer being 2.10 to 2.15. A silicon nitride film, a silicon oxynitride film, and a silicon oxide film, as the first functional layer for front-film hydrogen passivation and anti-reflection, is sequentially deposited on the first surface of the silicon wafer through the PECVD device, with a total thickness of the first functional layer being 75 nm to 85 nm and a refractive index of the first functional layer being 1.95 to 2.00.

It should be noted that, in the embodiments of the present application, there is no sequential limitation between the step of forming corresponding functional layers on the first surface of the silicon wafer and the step of forming corresponding functional layers on the second surface of the silicon wafer. That is, the corresponding functional layers on the first surface of the silicon wafer may be first formed, and then the corresponding functional layers on the second surface of the silicon wafer are formed, or vice versa, the corresponding functional layers on the second surface of the silicon wafer are first formed, and then the corresponding functional layers on the first surface of the silicon wafer are formed.

Finally, a silver paste is printed on the first surface of the silicon wafer and a silver-aluminum paste is printed on the second surface of the silicon wafer by screen printing, and the silicon wafer is sintered at 800°C to 850°C to fabricate the first electrode and the second electrode. Subsequently, the cell is subjected to optical injection at 650°C to 750°C. It should be understood that the first electrode and the second electrode may also be prepared respectively by printing the silver paste on the first surface and the silver-aluminum paste on the second surface of the silicon wafer.

It should be understood that in this embodiment, the first electrode may alternatively be obtained by printing the silver-aluminum paste, and the second electrode may alternatively be obtained by printing the silver paste. When the first doped crystalline silicon layer is the P+ type doped layer and the second doped crystalline silicon layer is the N+ type doped layer, the first electrode and the second electrode may be obtained by respectively printing the silver-aluminum paste on the first surface of the silicon wafer and printing the silver paste on the second surface of the silicon wafer, followed by sintering.

In a fourth aspect, embodiments of the present application further provide a photovoltaic module, including the solar cell described in the first aspect. The photovoltaic module is formed by connecting a plurality of the above-mentioned solar cells in series and/or parallel and performing encapsulation.

The performance of the solar cell prepared in the present application will be described below in conjunction with examples and test data.

### Example 1

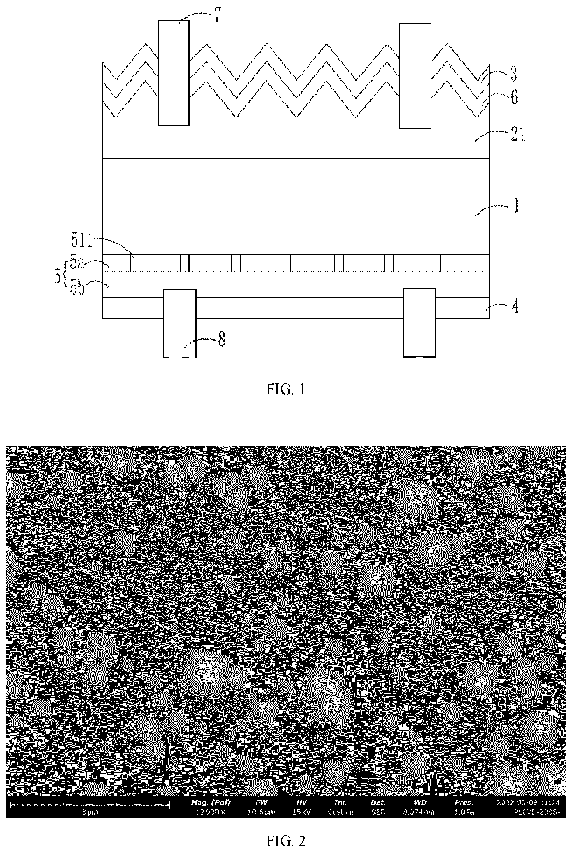

This example provides an N-type TOPCon solar cell. As shown in FIG. 1, the solar cell includes:
a silicon wafer 1, wherein a first diffusion layer 21, a third functional layer 6, and a first functional layer 3 are sequentially stacked on a first surface of the silicon wafer 1, a passivated contact structure 5 and a second functional layer 4 are sequentially stacked on a second surface of the silicon wafer 1, and the passivated contact structure 5 includes a passivation oxide layer 5a arranged proximate to the second surface of the silicon wafer 1 and a doped crystalline silicon layer 5b arranged away from the second surface of the silicon wafer 1;
a first electrode 7 penetrating through the first functional layer 3 and the third functional layer 6 to form an ohmic contact with the first diffusion layer 21; and
a second electrode 8 penetrating through the second functional layer 4 to form an ohmic contact with the doped crystalline silicon layer 5b.

A thickness of the passivation oxide layer 5a is 2 nm. A plurality of nanoscale micropores 511 are distributed in the passivation oxide layer 5a. A diameter of the micropores 511 is 50 nm to 500 nm. A quantity of the micropores 511 is 1×10⁴ pores/cm² to 1.6×10⁸ pores/cm². The doped crystalline silicon layer 5b is a fragmented crystalline silicon layer doped with phosphorus element, carbon element, and oxygen element. A doping concentration of the carbon element in the fragmented crystalline silicon layer is 3.3%. A doping concentration of the oxygen element in the fragmented crystalline silicon layer is 3.6%.

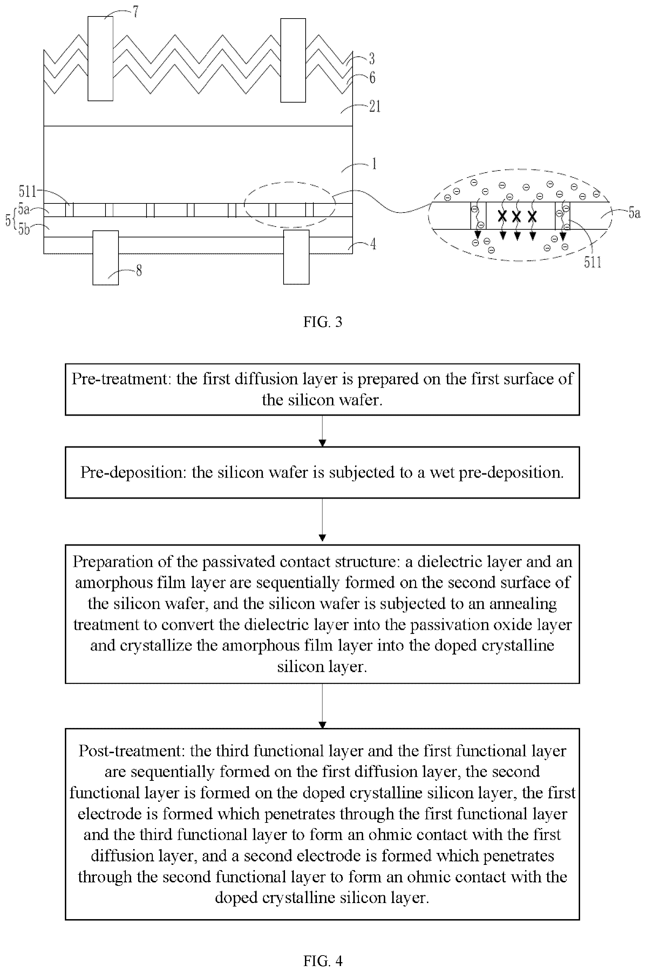

As shown in FIG. 2, FIG. 2 is an SEM image of the passivation oxide layer in the solar cell in this example. It can be observed from the image that a plurality of nanoscale micropores are distributed in the passivation oxide layer in this example. Continuing with FIG. 3, FIG. 3 is a schematic view showing a conduction principle of the passivation oxide layer in the solar cell in this example, from which it can be seen that in this example, at the positions of the passivation oxide layer where the micropores are formed, the carriers can directly pass through the conducting channels formed by the micropores, while at positions of the passivation oxide layer where no micropores are formed, the carriers cannot pass through directly, and it is also difficult for them to be conducted via tunneling. It is clear that in contrast to the principle in the related art that employs a very thin tunneling oxide layer for carrier conduction through tunneling, this example utilizes a thicker passivation oxide layer that enables direct conduction of carriers through the micropores formed within it, thereby reducing the series resistance of carrier transport and enhancing the carrier conductivity.

In conjunction with FIG. 4, the preparation method for the solar cell includes the following steps:
Pre-treatment: the first diffusion layer is prepared on the first surface of the silicon wafer.

Pre-deposition: the silicon wafer is subjected to a wet pre-deposition.

Preparation of the passivated contact structure: a dielectric layer and an amorphous film layer are sequentially formed on the second surface of the silicon wafer, and the silicon wafer is subjected to an annealing treatment to convert the dielectric layer into the passivation oxide layer and crystallize the amorphous film layer into the doped crystalline silicon layer.

Post-treatment: the third functional layer and the first functional layer are sequentially formed on the first diffusion layer, the second functional layer is formed on the doped crystalline silicon layer, the first electrode is formed which penetrates through the first functional layer and the third functional layer to form an ohmic contact with the first diffusion layer, and a second electrode is formed which penetrates through the second functional layer to form an ohmic contact with the doped crystalline silicon layer.

The pre-treatment step includes:
silicon wafer provision: an N-type 182-size M10 silicon wafer with a resistivity of 0.3 Ω·cm to 2.1 Ω·cm and a minority-carrier lifetime greater than 1 ms is used;
texturing: the silicon wafer is subjected to a rapid texturing using sodium hydroxide and an additive of model TS40 in a volume ratio of 7:1 at a temperature maintained at 80°C for 7 min in a tank-type device, with the thinning amount control to 5 µm;
boron diffusion: the textured silicon wafer is placed into a boron diffusion furnace, and a boron source is deposited using boron trichloride gas and oxygen gas in a volume ratio of 1:3 at a temperature of 830°C and then pushed at 1030°C for 1 h to form a P-N junction to obtain the first diffusion layer, with a sheet resistance after diffusion being 120 Ω/sq to 140 Q/sq;
alkaline polishing: the borosilicate glass wrapped around the second surface of the silicon wafer in the boron diffusion is removed with a hydrofluoric acid solution with a volume percentage of 50% through a chain-type HF machine, and then the silicon wafer is transferred by a robotic arm to a tank-type alkaline polishing machine, and the second surface of the silicon wafer is polished with sodium hydroxide and an alkaline polishing additive BP31 in a volume ratio of 3:1 at a temperature maintained at 80°C for 7 min to remove the P-N junction wrapped around the second surface and edges in the boron diffusion step.

The pre-deposition step is as follows: the alkali-polished silicon wafer is placed into a tank containing sodium hydroxide with a mass concentration of 4% and hydrogen peroxide, and a deposition is performed on the second surface of the silicon wafer for 2-5 min through a wet process to grow a dielectric layer SiOₓ with a thickness of 0.5 nm.

The step of preparing the passivated contact structure includes:
preparation of the passivated contact structure: a tubular PECVD device is used to continue depositing a composite film on the second surface of the silicon wafer that has been pre-deposited with the dielectric layer, with six films deposited at a pressure of 2500 mTorr to 3500 mTorr and a temperature of 350°C to 450°C, and with a total process time of 30 min to 60 min:
film layer 1: through PECVD, a dielectric layer SiOₓ with a thickness of 1.5 nm is deposited by introducing N₂O at 8 to 15 SLM for a time of 140 s, bringing the total thickness of the dielectric layer to 2 nm;
film layer 2: through PECVD, a first intrinsic layer with a thickness of 5 nm to 40 nm is deposited as an amorphous film layer by introducing SiH₄ and H₂ in a volume ratio of 1:2.5 for a time of 40 s to 90 s;
film layer 3: through PECVD, a first doped layer doped with phosphorus element and having a thickness of 20 nm to 60 nm is deposited as an amorphous film layer by introducing SiH₄, PH₃, and H₂ in a volume ratio of 1:0.8:2.5 for a time of 250 s to 350 s;
film layer 4: through PECVD, a second intrinsic layer doped with carbon element and oxygen element and having a thickness of 5 nm to 40 nm is deposited as an amorphous film layer by introducing SiH₄, H₂, and CO₂ in a volume ratio of 1:2.5:0.4 for a time of 40 s to 90 s;
film layer 5: through PECVD, a second doped layer doped with phosphorus element and having a thickness of 20 nm to 60 nm is deposited as an amorphous film layer by introducing SiH₄, PH₃, and H₂ in a volume ratio of 1:0.8:2.5 for a time of 250 s to 350 s;
film layer 6: through PECVD, a silicon oxynitride film with a thickness of 5 nm to 40 nm is deposited as a mask layer by introducing SiH₄ and N₂O in a volume ratio of 1:4.5 for a time of 60 s;
annealing: in a tubular annealing furnace, the silicon wafer deposited with the six films is annealed at an annealing temperature of 970°C for an annealing time of 80 min to 170 min under an atmosphere of nitrogen gas at 2 to 10 SLM, causing the film layer 1, the dielectric layer, of the film layers in the previous step to create pinhole-shaped cracks, and converting the crystalline structures of the amorphous film layers of the film layers 2, 3, 4, and 5 to fragmented crystalline states to form a fragmented crystalline silicon layer doped with the phosphorus element, the carbon element, and the oxygen element, which has the advantage of a wide band gap.

The post-treatment step includes:
RCA cleaning: the dielectric layer on only the first surface of the silicon wafer is firstly removed with hydrofluoric acid with a mass concentration of 5% through a chain-type HF machine, then the silicon wafer is transferred by a robotic arm into a tank-type alkaline polishing machine to remove the fragmented crystalline silicon layer wrapped around the surface of the silicon wafer in the annealing step using sodium hydroxide and an alkaline polishing additive BP31 in a volume ratio of 2:1 at a temperature maintained at 80°C for a time of 2 min, and finally the silicon wafer is transferred into an acid tank to remove the borosilicate glass on the first surface of the silicon wafer and the mask layer on the second surface of the silicon wafer using hydrofluoric acid with a mass concentration of 5%;
deposition of the third functional layer and the first functional layer: an aluminum oxide film with a thickness of 5 nm is deposited as the third functional layer for passivation through atomic layer deposition (ALD), and a silicon nitride film, a silicon oxynitride film, and a silicon oxide film are sequentially deposited as the first functional layer for anti-reflection on the first surface of the silicon wafer through PECVD, with a total thickness of the first functional layer controlled within 75 nm to 85 nm and a refractive index of the first functional layer controlled within 1.95 to 2.00;
deposition of the second functional layer: a silicon nitride film with a thickness of 75 nm to 80 nm and a refractive index of 2.10 to 2.15 is deposited as the second functional layer for back-film hydrogen passivation through PECVD;
screen printing: a silver paste is printed on the second surface and a silver-aluminum paste is printed on the first surface, followed by a sintering process at a temperature of 840°C to complete the electrode fabrication, and the cell is subjected to an optical injection at a process temperature of 700°C; and
testing of the photoelectric conversion efficiency of the cell and sorting.

### Example 2

The only difference between this example and Example 1 is that the thickness of the passivation oxide layer is 1.5 nm. Wherein, in the pre-deposition step, a dielectric layer SiOₓ with a thickness of 0.5 nm is grown, and in the step of preparing the layer 1, an additional dielectric layer SiOₓ with a thickness of 1 nm is deposited, resulting in a total thickness of the dielectric layer of 1.5 nm and thus a thickness of the passivation oxide layer obtained after the annealing treatment of 1.5 nm.

### Example 3

The only difference between this example and Example 1 is that the thickness of the passivation oxide layer is 3.5 nm. Wherein, in the pre-deposition step, a dielectric layer SiOₓ with a thickness of 0.5 nm is grown, and in the step of preparing the layer 1, an additional dielectric layer SiOₓ with a thickness of 3 nm is deposited, resulting in a total thickness of the dielectric layer of 3.5 nm and thus a thickness of the passivation oxide layer obtained after the annealing treatment of 3.5 nm.

### Example 4

The only difference between this example and Example 1 is that no second element is doped in the doped crystalline silicon layer.

### Example 5

The only difference between this example and Example 1 is that the second element in the doped crystalline silicon layer is carbon element.

### Example 6

The only difference between this example and Example 1 is that the second element in the doped crystalline silicon layer is oxygen element.

### Example 7

The only difference between this example and Example 1 is that the thickness of the doped crystalline silicon layer is 200 nm.

### Example 8

The only difference between this example and Example 1 is that the thickness of the doped crystalline silicon layer is 40 nm.

### Example 9

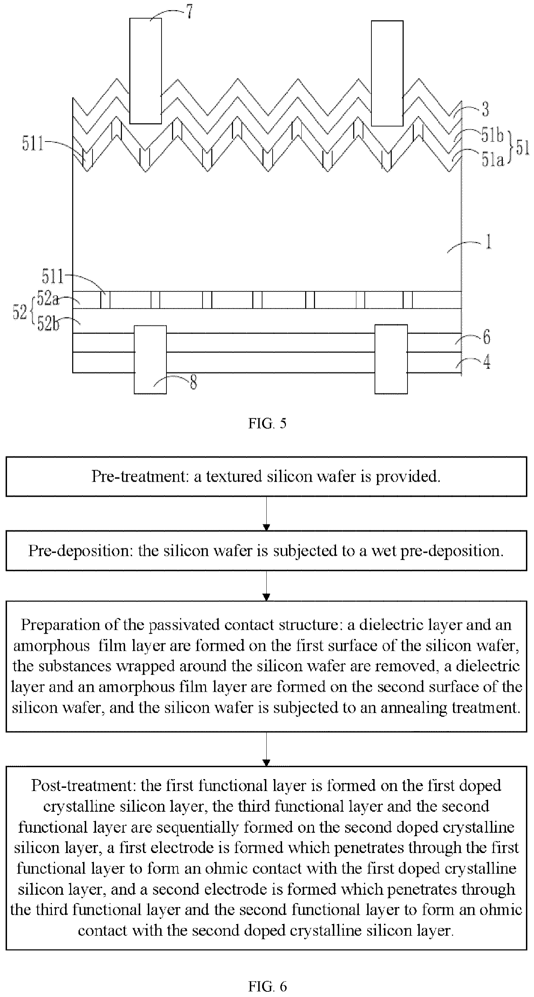

This example provides a TOPCon solar cell. As shown in FIG. 5, FIG. 5 is a schematic structural view of the solar cell according to this example. The solar cell includes:
a silicon wafer 1, wherein a first passivated contact structure 51 and a first functional layer 3 are sequentially stacked on a first surface of the silicon wafer 1, and a second passivated contact structure 52, a third functional layer 6, and a second functional layer 4 are sequentially stacked on a second surface of the silicon wafer 1; the first passivated contact structure 51 includes a first passivation oxide layer 51a arranged proximate to the first surface of the silicon wafer 1 and a first doped crystalline silicon layer 51b arranged away from the first surface of the silicon wafer 1, and the first functional layer 3 is stacked on the first doped crystalline silicon layer 51b; and the second passivated contact structure 52 includes a second passivation oxide layer 52a arranged proximate to the second surface of the silicon wafer 1 and a second doped crystalline silicon layer 52b arranged away from the second surface of the silicon wafer 1, and the third functional layer 6 is arranged between the second doped crystalline silicon layer 52b and the second functional layer 4;
a first electrode 7 penetrating through the first functional layer 3 to form an ohmic contact with the first doped crystalline silicon layer 51b; and
a second electrode 8 penetrating through the second functional layer 4 and the third functional layer 6 to form an ohmic contact with the second doped crystalline silicon layer 52b.

The first passivation oxide layer 51a and the second passivation oxide layer 52a have the same structure and parameters; therefore, the following will provide an introduction to the first passivation oxide layer 51a, while details regarding the second passivation oxide layer 52a will not be repeated. A thickness of the first passivation oxide layer 51a is 2 nm. A plurality of nanoscale micropores 511 are distributed in the first passivation oxide layer 51a. A diameter of the micropores 511 is 50 nm to 500 nm. A quantity of the micropores 511 is 1×10⁴ pores/cm² to 1.6×10⁸ pores/cm². The first doped crystalline silicon layer 51b is a fragmented crystalline silicon layer doped with phosphorus element, carbon element, and oxygen element, with a doping concentration of carbon element in the fragmented crystalline silicon layer being 3.3% and a doping concentration of oxygen element in the fragmented crystalline silicon layer being 3.6%. The second doped crystalline silicon layer 52b is a fragmented crystalline silicon layer doped with phosphorus element, carbon element, and oxygen element, with a doping concentration of carbon element in the fragmented crystalline silicon layer being 3.3% and a doping concentration of oxygen element in the fragmented crystalline silicon layer being 3.6%.

The conduction principle of the passivation oxide layer in the solar cell in this example is the same as that in Example 1 and will not be repeated.

In conjunction with FIG. 6, the preparation method for the solar cell includes the following steps:
Pre-treatment: a textured silicon wafer is provided.

Pre-deposition: the silicon wafer is subjected to a wet pre-deposition.

Preparation of the passivated contact structure: a dielectric layer and an amorphous film layer are sequentially formed on the first surface of the silicon wafer, the substances wrapped around the silicon wafer are removed, a dielectric layer and an amorphous film layer are formed on the second surface of the silicon wafer, and the silicon wafer is subjected to an annealing treatment to convert the dielectric layer on the first surface into the first passivation oxide layer and the dielectric layer on the second surface into the second passivation oxide layer, and to crystallize the amorphous film layer on the first surface into the first doped crystalline silicon layer and the amorphous film layer on the second surface into the second doped crystalline silicon layer.

Post-treatment: the first functional layer is formed on the first doped crystalline silicon layer, the third functional layer and the second functional layer are sequentially formed on the second doped crystalline silicon layer, a first electrode is formed which penetrates through the first functional layer to form an ohmic contact with the first doped crystalline silicon layer, and a second electrode is formed which penetrates through the third functional layer and the second functional layer to form an ohmic contact with the second doped crystalline silicon layer.

The pre-treatment step includes:
silicon wafer provision: an N-type 182-size M10 silicon wafer with a resistivity of 0.3 Ω·cm to 2.1 Ω·cm and a minority-carrier lifetime greater than 1 ms is used;
texturing: the silicon wafer is subjected to a rapid texturing using sodium hydroxide and an additive of model TS40 in a volume ratio of 7:1 at a temperature maintained at 80°C for 7 min in a tank-type device, with the thinning amount control to 5 µm.

The pre-deposition step is as follows: the textured silicon wafer is placed into a tank containing sodium hydroxide with a mass concentration of 4% and hydrogen peroxide, and a deposition is performed on the surface of the silicon wafer for 2-5 min through a wet process to grow a dielectric layer SiOₓ with a thickness of 0.5 nm.

The step of preparing the passivated contact structure includes:
preparation of the first passivated contact structure: a tubular PECVD device is used to continue depositing a composite film on the first surface of the silicon wafer that has been pre-deposited with the dielectric layer, with six films deposited at a pressure of 2500 mTorr to 3500 mTorr and a temperature of 350°C to 450°C, and with a total process time of 30 min to 60 min:
film layer 1: through PECVD, a dielectric layer SiOₓ with a thickness of 2.0 nm is deposited by introducing N₂O at 8 to 15 SLM for a time of 140 s;
film layer 2: through PECVD, a first intrinsic layer with a thickness of 5 nm to 40 nm is deposited as an amorphous film layer by introducing SiH₄ and H₂ in a volume ratio of 1:2.5 for a time of 40 s to 90 s;
film layer 3: through PECVD, a first doped layer doped with phosphorus element and having a thickness of 20 nm to 60 nm is deposited as an amorphous film layer by introducing SiH₄, PH₃, and H₂ in a volume ratio of 1:0.8:2.5 for a time of 250 s to 350 s;
film layer 4: through PECVD, a second intrinsic layer doped with carbon element and oxygen element and having a thickness of 5 nm to 40 nm is deposited as an amorphous film layer by introducing SiH₄, H₂, and CO₂ in a volume ratio of 1:2.5:0.4 for a time of 40 s to 90 s;
film layer 5: through PECVD, a second doped layer doped with phosphorus element and having a thickness of 20 nm to 60 nm is deposited as an amorphous film layer by introducing SiH₄, PH₃, and H₂ in a volume ratio of 1:0.8:2.5 for a time of 250 s to 350 s;
film layer 6: through PECVD, a silicon oxynitride film with a thickness of 5 nm to 40 nm is deposited as a mask layer by introducing SiH₄ and N₂O in a volume ratio of 1:4.5 for a time of 60 s;
alkaline polishing: the mask layer wrapped around the second surface of the silicon wafer in the boron diffusion is removed with a hydrofluoric acid solution with a volume percentage of 5% through a chain-type HF machine, and then the silicon wafer is transferred by a robotic arm to a tank-type alkaline polishing machine to polish the back surface of the silicon wafer and remove the first passivated contact structure wrapped around the second surface and edges of the silicon wafer in the previous step using sodium hydroxide and an alkaline polishing additive BP31 in a volume ratio of 3:1 at a temperature maintained at 80°C for 7 min;
pre-deposition: the alkali-polished silicon wafer is placed into a tank containing sodium hydroxide with a mass concentration of 4% and hydrogen peroxide, and a deposition is performed on the second surface of the silicon wafer for 2-5 min through a wet process to grow a dielectric layer SiOₓ with a thickness of 0.5 nm;
preparation of the second passivated contact structure: a tubular PECVD device is used to continue depositing a composite film on the second surface of the silicon wafer that has been pre-deposited with the dielectric layer on the second surface, with six films deposited at a pressure of 2500 mTorr to 3500 mTorr and a temperature of 350°C to 450°C, and with a total process time of 30 min to 60 min:
   film layer 1: through PECVD, a dielectric layer SiOₓ with a thickness of 2.0 nm is deposited by introducing N₂O at 8 to 15 SLM for a time of 140 s;
   film layer 2: through PECVD, a first intrinsic layer with a thickness of 5 nm to 40 nm is deposited as an amorphous film layer by introducing SiH₄ and H₂ in a volume ratio of 1:2.5 for a time of 40 s to 90 s;
   film layer 3: through PECVD, a first doped layer doped with boron element and having a thickness of 20 nm to 60 nm is deposited as an amorphous film layer by introducing SiH₄, B₂H₆, and H₂ in a volume ratio of 1:0.6:2.5 for a time of 250 s to 350 s;
   film layer 4: through PECVD, a second intrinsic layer doped with carbon element and oxygen element and having a thickness of 5 nm to 40 nm is deposited as an amorphous film layer by introducing SiH₄, H₂, and CO₂ in a volume ratio of 1:2.5:0.4 for a time of 40 s to 90 s;
   film layer 5: through PECVD, a second doped layer doped with phosphorus element and having a thickness of 20 nm to 60 nm is deposited as an amorphous film layer by introducing SiH₄, B₂H₆, and H₂ in a volume ratio of 1:0.6:2.5 for a time of 250 s to 350 s;
   film layer 6: through PECVD, a silicon oxynitride film with a thickness of 5 nm to 40 nm is deposited as a mask layer by introducing SiH₄ and N₂O in a volume ratio of 1:4.5 for a time of 60 s;
   annealing: in a tubular annealing furnace, the silicon wafer deposited with the six films is annealed at an annealing temperature of 970°C for an annealing time of 80 min to 170 min under an atmosphere of nitrogen gas at 2 to 10 SLM, causing the film layer 1, the dielectric layer, of the film layers in the previous step to create pinhole-shaped cracks, and converting the crystalline structures of the amorphous film layers of the film layers 2, 3, 4, and 5 to fragmented crystalline states to form a fragmented crystalline silicon layer doped with the phosphorus or boron element, the carbon element, and the oxygen element, which has the advantage of a wide band gap.

The post-treatment step includes:
RCA cleaning: the mask layer on only the first surface of the silicon wafer is firstly removed with hydrofluoric acid with a mass concentration of 5% through a chain-type HF machine, then the silicon wafer is transferred by a robotic arm into a tank-type alkaline polishing machine to remove the fragmented crystalline silicon layer wrapped around the first surface of the silicon wafer in the annealing step using sodium hydroxide and an alkaline polishing additive BP31 in a volume ratio of 2:1 at a temperature maintained at 80°C for a time of 2 min, and finally the silicon wafer is transferred into an acid tank to remove the mask layer on the first surface and the second surface of the silicon wafer using hydrofluoric acid with a mass concentration of 5%;
deposition of the third functional layer and the second functional layer: on basis of the formed second passivated contact structure, an aluminum oxide film with a thickness of 5 nm is deposited as the third functional layer on the second surface of the silicon wafer for passivation through atomic layer deposition (ALD), and a silicon nitride film is deposited as the second functional layer as a protection layer on the second surface of the silicon wafer through PECVD, with a total thickness of the second functional layer controlled within 75 nm to 85 nm and a refractive index of the second functional layer controlled within 2.10 to 2.15;
deposition of the first functional layer: on basis of the formed first passivated contact structure, a silicon nitride film, a silicon oxynitride film, and a silicon oxide film are sequentially deposited on the first surface of the silicon wafer as the first functional layer for front film hydrogen passivation and anti-reflection through PECVD, with a thickness of the first functional layer controlled within 75 nm to 85 nm and a refractive index of the first functional layer controlled within 1.95 to 2.00;
screen printing: a silver-aluminum paste is printed on the second surface and a silver paste is printed on the first surface, followed by a sintering process at a temperature of 840°C to complete the electrode fabrication, and the cell is subjected to an optical injection at a process temperature of 700°C; and
testing of the photoelectric conversion efficiency of the cell and sorting.

### Example 10

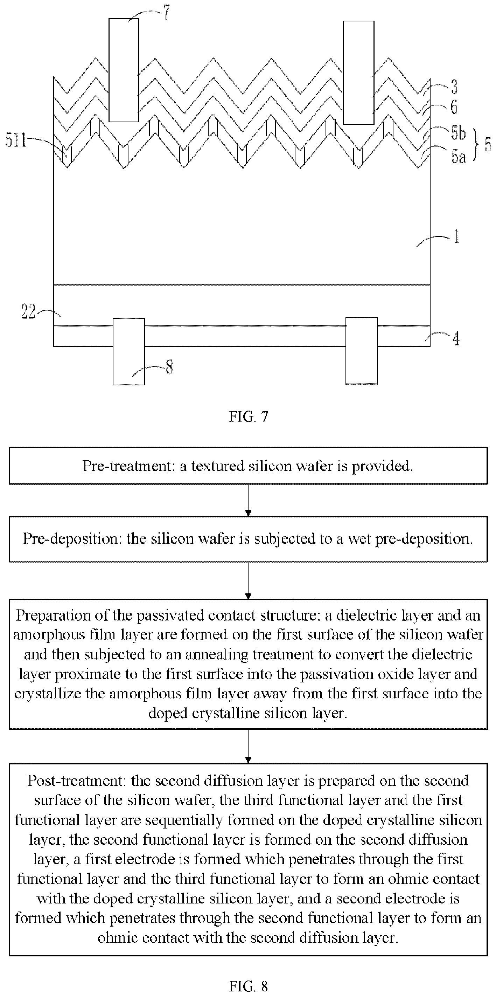

This example provides a TOPCon solar cell. As shown in FIG. 7, FIG. 7 is a schematic structural view of a solar cell according to this example. The solar cell includes:
a silicon wafer 1, wherein a passivated contact structure 5, a third functional layer 6, and a first functional layer 3 are sequentially stacked on a first surface of the silicon wafer 1, a second diffusion layer 22 and a second functional layer 4 are sequentially stacked on a second surface of the silicon wafer 1, the passivated contact structure 5 includes a passivation oxide layer 5a arranged proximate to the first surface of the silicon wafer 1 and a doped crystalline silicon layer 5b arranged away from the first surface of the silicon wafer 1, and the third functional layer 6 is stacked on the doped crystalline silicon layer 5b;
a first electrode 7 penetrating through the first functional layer 3 and the third functional layer 6 to form an ohmic contact with the doped crystalline silicon layer 5b; and
a second electrode 8 penetrating through the second functional layer 4 to form an ohmic contact with the second diffusion layer 22.

A thickness of the passivation oxide layer 5a is 2 nm. A plurality of nanoscale micropores 511 are distributed in the passivation oxide layer 5a. A diameter of the micropores 511 is 50 nm to 500 nm. A quantity of the micropores 511 is 1×10⁴ pores/cm² to 1.6×10⁸ pores/cm². The doped crystalline silicon layer 5b is a fragmented crystalline silicon layer doped with phosphorus element, carbon element, and oxygen element. A doping concentration of the carbon element in the fragmented crystalline silicon layer is 3.3%. A doping concentration of the oxygen element in the fragmented crystalline silicon layer is 3.6%.

The conduction principle of the passivation oxide layer in the solar cell in this example is the same as that in Example 1 and will not be repeated.

In conjunction with FIG. 8, the preparation method for the solar cell includes the following steps:
Pre-treatment: a textured silicon wafer is provided.

Pre-deposition: the silicon wafer is subjected to a wet pre-deposition.

Preparation of the passivated contact structure: a dielectric layer and an amorphous film layer are sequentially formed on the first surface of the silicon wafer, and the silicon wafer is subjected to an annealing treatment to convert the dielectric layer proximate to the first surface into the passivation oxide layer and crystallize the amorphous film layer away from the first surface into the doped crystalline silicon layer.

Post-treatment: the second diffusion layer is prepared on the second surface of the silicon wafer, the third functional layer and the first functional layer are sequentially formed on the doped crystalline silicon layer, the second functional layer is formed on the second diffusion layer, a first electrode is formed which penetrates through the first functional layer and the third functional layer to form an ohmic contact with the doped crystalline silicon layer, and a second electrode is formed which penetrates through the second functional layer to form an ohmic contact with the second diffusion layer.

The pre-treatment step includes:
silicon wafer provision: an N-type 182-size M10 silicon wafer with a resistivity of 0.3 Ω·cm to 2.1 Ω·cm and a minority-carrier lifetime greater than 1 ms is used;
texturing: the silicon wafer is subjected to a rapid texturing using sodium hydroxide and an additive of model TS40 in a volume ratio of 7:1 at a temperature maintained at 80°C for 7 min in a tank-type device, with the thinning amount control to 5 µm.

The pre-deposition step is as follows: the textured silicon wafer is placed into a tank containing sodium hydroxide with a mass concentration of 4% and hydrogen peroxide, and a deposition is performed on the second surface of the silicon wafer for 2-5 min through a wet process to grow a dielectric layer SiOₓ with a thickness of 0.5 nm.

The step of preparing the passivated contact structure includes:
preparation of the passivated contact structure: a tubular PECVD device is used to continue depositing a composite film on the first surface of the silicon wafer that has been pre-deposited with the dielectric layer on the first surface, with six films deposited at a pressure of 2500 mTorr to 3500 mTorr and a temperature of 350°C to 450°C, and with a total process time of 30 min to 60 min:
film layer 1: through PECVD, a dielectric layer SiOₓ with a thickness of 2.0 nm is deposited by introducing N₂O at 8 to 15 SLM for a time of 140 s;
film layer 2: through PECVD, a first intrinsic layer with a thickness of 5 nm to 40 nm is deposited as an amorphous film layer by introducing SiH₄ and H₂ in a volume ratio of 1:2.5 for a time of 40 s to 90 s;
film layer 3: through PECVD, a first doped layer doped with boron element and having a thickness of 20 nm to 60 nm is deposited as an amorphous film layer by introducing SiH₄, B₂H₆, and H₂ in a volume ratio of 1:0.6:2.5 for a time of 250 s to 350 s;
film layer 4: through PECVD, a second intrinsic layer doped with carbon element and oxygen element and having a thickness of 5 nm to 40 nm is deposited as an amorphous film layer by introducing SiH₄, H₂, and CO₂ in a volume ratio of 1:2.5:0.4 for a time of 40 s to 90 s;
film layer 5: through PECVD, a first doped layer doped with boron element and having a thickness of 20 nm to 60 nm is deposited as an amorphous film layer by introducing SiH₄, B₂H₆, and H₂ in a volume ratio of 1:0.6:2.5 for a time of 250 s to 350 s;
film layer 6: through PECVD, a silicon oxynitride film with a thickness of 5 nm to 40 nm is deposited as a mask layer by introducing SiH₄ and N₂O in a volume ratio of 1:4.5 for a time of 60 s;
annealing: in a tubular annealing furnace, the silicon wafer deposited with the six films is annealed at an annealing temperature of 970°C for an annealing time of 80 min to 170 min under an atmosphere of nitrogen gas at 2 to 10 SLM, causing the film layer 1, the dielectric layer, of the film layers in the previous step to create pinhole-shaped cracks, and converting the crystalline structures of the amorphous film layers of the film layers 2, 3, 4, and 5 to fragmented crystalline states to form a fragmented crystalline silicon layer doped with the phosphorus element, the carbon element, and the oxygen element, which has the advantage of a wide band gap.

The post-treatment step includes:
alkaline polishing: the mask layer wrapped around the second surface of the silicon wafer in the boron diffusion is removed with a hydrofluoric acid solution with a volume percentage of 5% through a chain-type HF machine, and then the silicon wafer is transferred by a robotic arm to a tank-type alkaline polishing machine to polish the second surface of the silicon wafer and remove the passivated contact structure wrapped around the second surface and edges in the previous step using sodium hydroxide and an alkaline polishing additive BP31 in a volume ratio of 3:1 at a temperature maintained at 80°C for 7 min;
formation of the second diffusion layer: a phosphorus diffused layer is formed as the second diffusion layer through deposition and junction pushing;
RCA cleaning: the mask layer on only the second surface of the silicon wafer is firstly removed with hydrofluoric acid with a mass concentration of 5% through a chain-type HF machine, then the silicon wafer is transferred by a robotic arm into a tank-type alkaline polishing machine to remove the fragmented crystalline silicon layer wrapped around the second surface of the silicon wafer in the annealing step using sodium hydroxide and an alkaline polishing additive BP31 in a volume ratio of 2:1 at a temperature maintained at 80°C for a time of 2 min, and finally the silicon wafer is transferred into an acid tank to remove the borosilicate glass on the second surface of the silicon wafer and the mask layer on the first surface of the silicon wafer using hydrofluoric acid with a mass concentration of 5%;
deposition of the third functional layer and the first functional layer: an aluminum oxide film with a thickness of 5 nm is deposited as the third functional layer for passivation through atomic layer deposition (ALD), and a silicon nitride film, a silicon oxynitride film, and a silicon oxide film are sequentially deposited as the first functional layer on the first surface of the silicon wafer for anti-reflection through PECVD, with a total thickness of the first functional layer controlled within 75 nm to 85 nm and a refractive index of the first functional layer controlled within 1.95 to 2.00;
deposition of the second functional layer: a silicon nitride film with a thickness of 75 nm to 80 nm and a refractive index of 2.10 to 2.15 is deposited as the second functional layer for back-film hydrogen passivation through PECVD;
screen printing: a silver paste is printed on the second surface and a silver-aluminum paste is printed on the first surface, followed by a sintering process at a temperature of 840°C to complete the electrode fabrication, and the cell is subjected to an optical injection at a process temperature of 700°C; and
testing of the photoelectric conversion efficiency of the cell and sorting.

### Example 11

This example provides an N-type TOPCon solar cell, differing from Example 1 only in the step of preparing the passivated contact structure.

In the preparation method for the solar cell in this example, the step of preparing the passivated contact structure includes: a tubular PECVD device is used to continue depositing a composite film on the second surface of the silicon wafer that has been pre-deposited with the dielectric layer on the second surface, with six films deposited at a pressure of 2500 mTorr to 3500 mTorr and a temperature of 350°C to 450°C, and with a total process time of 30 min to 60 min:
film layer 1: through PECVD, a dielectric layer SiOₓ with a thickness of 1.5 nm is deposited by introducing N₂O at 8 to 15 SLM for a time of 140 s;
film layer 2: through PECVD, a first intrinsic layer doped with carbon element and oxygen element and having a thickness of 5 nm to 40 nm is deposited as an amorphous film layer by introducing SiH₄, H₂, and CO₂ in a volume ratio of 1:2.5:0.4 for a time of 40 s to 90 s;
film layer 3: through PECVD, a first doped layer doped with phosphorus element and having a thickness of 20 nm to 60 nm is deposited as an amorphous film layer by introducing SiH₄, PH₃, and H₂ in a volume ratio of 1:0.8:2.5 for a time of 420 s to 600 s;
film layer 4: through PECVD, a silicon oxynitride film with a thickness of 5 nm to 40 nm is deposited as a mask layer by introducing SiH₄ and N₂O in a volume ratio of 1:4.5 for a time of 60 s;
annealing: in a tubular annealing furnace, the silicon wafer deposited with the four films is annealed at an annealing temperature of 970°C for an annealing time of 80 min to 170 min under an atmosphere of nitrogen gas at 2 to 10 SLM, causing the film layer 1, the dielectric layer, of the film layers in the previous step to create pinhole-shaped cracks, and converting the crystalline structures of the amorphous film layers of the film layers 2 and 3 to fragmented crystalline states to form a fragmented crystalline silicon layer doped with the phosphorus element, the carbon element, and the oxygen element, which has the advantage of a wide band gap.

### Example 12

This example provides an N-type TOPCon solar cell, differing from Example 1 only in the absence of the pre-deposition step before the step of preparing the passivated contact structure, that is, the wet pre-deposition of the dielectric layer is not performed in this example. A thickness of the passivation oxide layer is 2 nm in this example. Due to the absence of pre-deposition, in the step of preparing the film layer 1, a dielectric layer SiOₓ with a thickness of 2 nm is deposited, resulting in the passivation oxide layer with a thickness of 2 nm after the annealing treatment.

### Comparative Example 1

This comparative example provides an N-type TOPCon solar cell, differing from Example 1 primarily in the step of preparing the passivated contact structure and corresponding structure.

In the step of preparing the passivated contact structure, this comparative example employs an LPCVD device to deposit a composite film on the second surface of the silicon. The deposition of the film is achieved under near-vacuum conditions, for a total time of 120 min. Specifically:
Film layer 1: through high-temperature thermal oxidation, a passivation oxide layer with a thickness of 1 nm is deposited at 550°C to 650°C by introducing O₂.
Film layer 2: through LPCVD, an intrinsic amorphous silicon film with a thickness of 60 nm to 150 nm is deposited by introducing SiH₄.
Film layer 3: in a tubular diffusion furnace, the silicon wafer is subjected to phosphorus diffusion at a temperature of 850°C to 950°C for a time of 90 min to 150 min under an atmosphere of nitrogen gas at 2 to 10 SLM, oxygen gas at 2 to 10 SLM, and vaporized phosphorus oxychloride at 300 sccm to 1500 sccm, so that the intrinsic amorphous silicon film deposited in the previous step is doped with phosphorus and formed into a phosphorus-doped polysilicon layer.

The passivated contact structure of the solar cell in this comparative example differs from that in Example 1 mainly in the following aspects:
Firstly, in this comparative example, a thinner tunneling oxide layer is formed directly through high-temperature thermal oxidation, with no nanoscale micropores formed in this layer.

Secondly, in this comparative example, the doped crystalline silicon layer is a phosphorus-doped polysilicon layer formed through LPCVD and tubular diffusion furnace, without forming a fragmented crystalline silicon layer or being doped with a second element.

### Comparative Example 2

The only difference between this comparative example and Comparative Example 1 is in that the thickness of the passivation oxide layer is 1.4 nm.

### Comparative Example 3

The only difference between this comparative example and Comparative Example 1 is in that the thickness of the passivation oxide layer is 3.8 nm.

### Performance Test

In the present application, the solar cells provided in the above-mentioned examples and comparative examples are tested with a performance such as an open-circuit voltage, a short-circuit current, and a fill factor with halm testing and sorting device. The halm device is a device that simulates sunlight and is equipped with devices such as electronic loads and data collection and calculation, which is used to test the electrical property of photovoltaic devices (including the solar cells). The silicon wafer of the solar cell to be tested is controlled to be of 182 size, and a calibrated light intensity is controlled to be 1000+5 W/m². Experimental test results are shown in Table 1.

**Table 1 Performance Test Results of Solar Cells**

| Sample No. | Open-circuit voltage (V) | Short-circuit current (mA/cm²) | Fill factor (%) | Photoelectric conversion efficiency (%) |
|---|---|---|---|---|
| Example 1 | 0.7185 | 41.73 | 83.78 | 25.12 |
| Example 2 | 0.7172 | 41.66 | 83.83 | 25.05 |
| Example 3 | 0.7186 | 41.71 | 83.60 | 25.06 |
| Example 4 | 0.7179 | 41.55 | 83.84 | 25.01 |
| Example 5 | 0.7185 | 41.63 | 83.82 | 25.07 |
| Example 6 | 0.7177 | 41.65 | 83.80 | 25.05 |
| Example 7 | 0.7190 | 41.60 | 83.85 | 25.08 |
| Example 8 | 0.7175 | 41.80 | 83.02 | 24.90 |
| Example 9 | 0.7235 | 41.52 | 84.09 | 25.26 |
| Example 10 | 0.7154 | 41.55 | 83.70 | 24.88 |
| Example 11 | 0.7183 | 41.72 | 83.69 | 25.08 |
| Example 12 | 0.7156 | 41.68 | 83.35 | 24.86 |
| Comparative Example 1 | 0.7163 | 41.49 | 83.95 | 24.95 |
| Comparative Example 2 | 0.7159 | 41.43 | 83.72 | 24.83 |
| Comparative Example 3 | 0.7133 | 41.21 | 81.51 | 23.96 |

From the above test results, it can be observed that in the solar cells in the examples of the present application, the modification of the passivation oxide layer of the passivated contact structure, especially the modification of both the passivation oxide layer and the doped crystalline silicon layer, not only can reduce the interface defect density of the silicon wafer and optimize the passivation effect, but also can change the principle of carrier transport from tunneling conduction to direct conduction, thereby ensuring low series resistance of carrier transport. On this basis, the fragmented crystalline film layer doped with the second element also has a wider band gap than the polysilicon layer doping with no second element, which helps reduce the parasitic absorption and further improves the photoelectric conversion efficiency.

The passivated contact structure, the solar cell and the preparation method therefor, and the photovoltaic module disclosed in the embodiments of the present application are described in detail above. Specific examples are used herein to elucidate the principles and implementations of the present application. The descriptions of the above embodiments are merely intended to aid in understanding the technical solutions and core concepts of the present application. Meanwhile, for those of ordinary skill in the art, variations may be made on the specific embodiments and application scopes based on the concepts of the present application. In summary, the content of this specification should not be construed as limiting the present application.

## Claims

1. A passivated contact structure for a solar cell, comprising a passivation oxide layer arranged proximate to a silicon wafer of the solar cell and a doped crystalline silicon layer arranged away from the silicon wafer, wherein a thickness of the passivation oxide layer is 1.5 nm to 3.5 nm, and a plurality of nanoscale micropores are distributed in the passivation oxide layer.

2. The passivated contact structure according to claim 1, wherein a diameter of the micropores is 50 nm to 500 nm.

3. The passivated contact structure according to claim 1 or 2, wherein a quantity of the micropores is 1×10⁴ pores/cm² to 1.6×10⁸ pores/cm².

4. The passivated contact structure according to claim 1 or 2, wherein the doped crystalline silicon layer is a fragmented crystalline silicon layer doped with a first element and a second element, the first element is phosphorus element or boron element, and the second element is at least one of nitrogen element, carbon element, or oxygen element.

5. The passivated contact structure according to claim 4, wherein a concentration of the second element in the fragmented crystalline silicon layer is greater than 3%.

6. The passivated contact structure according to claim 5, wherein a band gap of the fragmented crystalline silicon layer is at least 0.3 eV greater than that of the silicon wafer.

7. The passivated contact structure according to claim 4, wherein a thickness of the fragmented crystalline silicon layer is 40 nm to 200 nm.

8. The passivated contact structure according to claim 7, wherein a size of a crystalline grain of the fragmented crystalline silicon layer is 30 nm to 100 nm.

9. A solar cell, comprising:
a silicon wafer having a first surface and a second surface opposite to each other, the first surface being a light-incident surface; and
a passivated contact structure arranged on the first surface and/or the second surface of the silicon wafer, the passivated contact structure comprising a passivation oxide layer arranged proximate to the silicon wafer and a doped crystalline silicon layer arranged away from the silicon wafer, a thickness of the passivation oxide layer being 1.5 nm to 3.5 nm, and a plurality of nanoscale micropores being distributed in the passivation oxide layer.

10. The solar cell according to claim 9, wherein the passivated contact structure is arranged on the second surface of the silicon wafer, the passivation oxide layer is arranged proximate to the second surface, and the doped crystalline silicon layer is arranged away from the second surface.

11. The solar cell according to claim 10, further comprising:
a first diffusion layer and a first functional layer sequentially stacked on the first surface of the silicon wafer, one of the first diffusion layer and the doped crystalline silicon layer being a P+ type doped layer, and the other of the first diffusion layer and the doped crystalline silicon layer being an N+ type doped layer;
a second functional layer arranged on a side of the doped crystalline silicon layer away from the second surface; and
a third functional layer located on the surface where the P+ type doped layer is arranged, the third functional layer being arranged between the first functional layer and the first diffusion layer or between the second functional layer and the doped crystalline silicon layer.

12. The solar cell according to claim 11, further comprising:
a first electrode forming an ohmic contact with the first diffusion layer; and
a second electrode forming an ohmic contact with the doped crystalline silicon layer.

13. The solar cell according to claim 9, wherein the passivated contact structure is arranged on the first surface of the silicon wafer, the passivation oxide layer is arranged proximate to the first surface, and the doped crystalline silicon layer is arranged away from the first surface.

14. The solar cell according to claim 13, further comprising:
a first functional layer arranged on a side of the doped crystalline silicon layer away from the first surface;
a second diffusion layer and a second functional layer sequentially stacked on the second surface of the silicon wafer, one of the second diffusion layer and the doped crystalline silicon layer being a P+ type doped layer, and the other of the second diffusion layer and the doped crystalline silicon layer being an N+ type doped layer; and
a third functional layer located on the surface where the P+ type doped layer is arranged, the third functional layer being arranged between the first functional layer and the doped crystalline silicon layer or between the second functional layer and the second diffusion layer.

15. The solar cell according to claim 14, further comprising:
a first electrode forming an ohmic contact with the doped crystalline silicon layer; and
a second electrode forming an ohmic contact with the second diffusion layer.

16. The solar cell according to claim 9, wherein the passivated contact structure comprises a first passivated contact structure arranged on the first surface of the silicon wafer and a second passivated contact structure arranged on the second surface of the silicon wafer; the first passivated contact structure comprises a first passivation oxide layer and a first doped crystalline silicon layer, with the first passivation oxide layer arranged proximate to the first surface and the first doped crystalline silicon layer arranged away from the first surface; the second passivated contact structure comprises a second passivation oxide layer and a second doped crystalline silicon layer, with the second passivation oxide layer arranged proximate to the second surface and the second doped crystalline silicon layer arranged away from the second surface; and one of the first doped crystalline silicon layer and the second doped crystalline silicon layer is a P+ type doped layer, and the other of the first doped crystalline silicon layer and the second doped crystalline silicon layer is an N+ type doped layer.

17. The solar cell according to claim 16, further comprising:
a first functional layer arranged on a side of the first doped crystalline silicon layer away from the first surface;
a second functional layer arranged on a side of the second doped crystalline silicon layer away from the second surface; and
a third functional layer located on the surface where the P+ type doped layer is arranged, the third functional layer being arranged between the first functional layer and the first doped crystalline silicon layer or between the second functional layer and the second doped crystalline silicon layer.

18. The solar cell according to claim 17, further comprising:
a first electrode forming an ohmic contact with the first doped crystalline silicon layer; and
a second electrode forming an ohmic contact with the second doped crystalline silicon layer.

19. The solar cell according to any one of claims 9 to 18, wherein a diameter of the micropores is 50 nm to 500 nm.

20. The solar cell according to any one of claims 9 to 18, wherein a quantity of the micropores is 1×10⁴ pores/cm² to 1.6×10⁸ pores/cm².

21. The solar cell according to any one of claims 9 to 18, wherein the doped crystalline silicon layer is a fragmented crystalline silicon layer doped with a first element and a second element, the first element is phosphorus element or boron element, and the second element is at least one of nitrogen element, carbon element, or oxygen element.

22. The solar cell according to claim 21, wherein a concentration of the second element in the fragmented crystalline silicon layer is greater than 3%.

23. The solar cell according to claim 22, wherein a band gap of the fragmented crystalline silicon layer is at least 0.3 eV greater than that of the silicon wafer.

24. The solar cell according to claim 21, wherein a thickness of the fragmented crystalline silicon layer is 40 nm to 200 nm.

25. The solar cell according to claim 24, wherein a size of a crystalline grain of the fragmented crystalline silicon layer is 30 nm to 100 nm.

26. The solar cell according to any one of claims 10 to 18, wherein a morphology of the silicon wafer is a polished surface, a random pyramid textured surface, or an inverted pyramid textured surface.

27. The solar cell according to any one of claims 11, 14, or 17, wherein the first functional layer is at least one of a silicon nitride layer, a silicon oxynitride layer, or a silicon oxide layer.

28. The solar cell according to any one of claims 11, 14, or 17, wherein the second functional layer is at least one of a silicon nitride layer, a silicon oxynitride layer, or a silicon oxide layer.

29. The solar cell according to any one of claims 11, 14, or 17, wherein the third functional layer is an aluminum oxide layer.

30. A preparation method for the solar cell according to any one of claims 9 to 29, comprising the following steps:
preparing the passivated contact structure: forming a dielectric layer and an amorphous film layer on the first surface and/or the second surface of the silicon wafer, and subjecting the silicon wafer formed with the dielectric layer and the amorphous film layer to an annealing treatment, to convert the dielectric layer into the passivation oxide layer and crystallize the amorphous film layer into the doped crystalline silicon layer, wherein a thickness of the passivation oxide layer is 1.5 nm to 3.5 nm, and a plurality of nanoscale micropores are formed in the passivation oxide layer.

31. The preparation method according to claim 30, wherein the step of preparing the passivated contact structure comprises:
sequentially depositing the dielectric layer, a first intrinsic layer doped with a second element, a first doped layer doped with a first element, and a mask layer on the silicon wafer, wherein the first intrinsic layer and the first doped layer are the amorphous film layer; and
performing the annealing treatment after the deposition to cause the first intrinsic layer and the first doped layer to collectively form the doped crystalline silicon layer, wherein the doped crystalline silicon layer is a fragmented crystalline silicon layer doped with the first element and the second element, the first element is phosphorus element or boron element, and the second element is at least one of nitrogen element, carbon element, or oxygen element.

32. The preparation method according to claim 31, wherein in the step of preparing the passivated contact structure, conditions for depositing the dielectric layer comprise: using a PECVD method, introducing N₂O at 8 SLM to 15 SLM, for a time of 80 s to 200 s.

33. The preparation method according to claim 31, wherein conditions for depositing the first intrinsic layer comprise: using a PECVD method, introducing SiH₄, H₂, and YₐO_{b} in a volume ratio of 1:(2 to 4):(0.1 to 1), for a deposition time of 20 s to 120 s, wherein Y in the YₐO_{b} is selected from carbon element, nitrogen element, or oxygen element, a is selected from 0, 1, 2, 3, or 4, and b is selected from 1, 2, 3, or 4.

34. The preparation method according to claim 31, wherein conditions for depositing the first doped layer comprise: using a PECVD method, introducing SiH₄, XₘHₙ, and H₂ in a volume ratio of 1:(0.5 to 1):(2 to 4), for a deposition time of 200 s to 600 s, wherein Y in the XₘHₙ is selected from phosphorous element or boron element, m is selected from 1 or 2, and n is selected from 3 or 6.

35. The preparation method according to claim 31, wherein a thickness of the dielectric layer is 1.5 nm to 3.5 nm.

36. The preparation method according to claim 31, wherein a thickness of the first intrinsic layer is 10 nm to 40 nm.

37. The preparation method according to claim 31, wherein a thickness of the first doped layer is 50 nm to 100 nm.

38. The preparation method according to claim 30, wherein the step of preparing the passivated contact structure comprises:
sequentially depositing the dielectric layer, a first intrinsic layer, a first doped layer doped with a first element, a second intrinsic layer doped with a second element, a second doped layer doped with the first element, and a mask layer on the silicon wafer, wherein the first intrinsic layer, the first doped layer, the second intrinsic layer, and the second doped layer are the amorphous film layer; and
performing the annealing treatment after the deposition to cause the first intrinsic layer, the first doped layer, the second intrinsic layer, and the second doped layer to collectively form the doped crystalline silicon layer, wherein the doped crystalline silicon layer is a fragmented crystalline silicon layer doped with the first element and the second element, the first element is phosphorus element or boron element, and the second element is at least one of nitrogen element, carbon element, or oxygen element.

39. The preparation method according to claim 38, wherein conditions for depositing the dielectric layer comprise: using a PECVD method, introducing N₂O at 8 SLM to 15 SLM, for a time of 80 s to 200 s.

40. The preparation method according to claim 38, wherein conditions for depositing the first intrinsic layer comprise: using a PECVD method, introducing SiH₄ and H₂ in a volume ratio of 1:(2 to 4), for a deposition time of 20 s to 120 s.

41. The preparation method according to claim 38, wherein conditions for depositing the first doped layer comprise: using a PECVD method, introducing SiH₄, XₘHₙ, and H₂ in a volume ratio of 1:(0.5 to 1):(2 to 4), for a deposition time of 200 s to 350 s, wherein X in the XₘHₙ is selected from phosphorous element or boron element, m is selected from 1 or 2, and n is selected from 3 or 6.

42. The preparation method according to claim 38, wherein conditions for depositing the second intrinsic layer comprise: using a PECVD method, introducing SiH₄, H₂, and YₐO_{b} in a volume ratio of 1:(2 to 4):(0.1 to 1), for a deposition time of 20 s to 120 s, wherein Y in the YₐO_{b} is selected from carbon element, nitrogen element, or oxygen element, a is selected from 0, 1, 2, 3, or 4, and b is selected from 1, 2, 3, or 4.

43. The preparation method according to claim 38, wherein conditions for depositing the second doped layer comprise: using a PECVD method, introducing SiH₄, XₘHₙ, and H₂ in a volume ratio of 1:(0.5 to 1):(2 to 4), for a deposition time of 200 s to 350 s, wherein X in the XₘHₙ is selected from phosphorous element or boron element, m is selected from 1 or 2, and n is selected from 3 or 6.

44. The preparation method according to claim 38, wherein a thickness of the dielectric layer is 1.5 nm to 3.5 nm.

45. The preparation method according to claim 38, wherein a thickness of the first intrinsic layer is 5 nm to 40 nm.

46. The preparation method according to claim 38, wherein a thickness of the first doped layer is 20 nm to 60 nm.

47. The preparation method according to claim 38, wherein a thickness of the second intrinsic layer is 5 nm to 40 nm.

48. The preparation method according to claim 38, wherein a thickness of the second doped layer is 20 nm to 60 nm.

49. The preparation method according to claim 30, wherein in the step of preparing the passivated contact structure, the dielectric layer and the amorphous film layer are deposited at a temperature of 350°C to 500°C for a deposition time of 30 min to 60 min; a temperature of the annealing treatment is 930°C to 1050°C, and a time of the annealing treatment is 50 min to 170 min.

50. The preparation method according to claim 30, further comprising performing a pre-deposition step before the step of preparing the passivated contact structure, wherein the pre-deposition step involves pre-depositing the dielectric layer through a wet process.

51. The preparation method according to claim 50, wherein the pre-deposition step involves pre-depositing the dielectric layer with a thickness of 0.3 nm to 0.7 nm on the silicon wafer through the wet process for a pre-deposition time of 2 min to 5 min.

52. The preparation method according to any one of claims 30 to 51, wherein the step of preparing the passivated contact structure involves sequentially forming the dielectric layer and the amorphous film layer on the second surface of the silicon wafer, followed by the annealing treatment to form a passivation oxide layer proximate to the second surface and a doped crystalline silicon layer away from the second surface;
the preparation method further comprises a pre-treatment step before the step of preparing the passivated contact structure, wherein the pre-treatment step involves preparing a first diffusion layer on the first surface of the silicon wafer, one of the first diffusion layer and the doped crystalline silicon layer is a P+ type doped layer, and the other of the first diffusion layer and the doped crystalline silicon layer is an N+ type doped layer; and
the preparation method further comprises a post-treatment step after the step of preparing the passivated contact structure, and the post-treatment step involves: forming a first functional layer on the first diffusion layer and forming a second functional layer on the doped crystalline silicon layer; forming a third functional layer on the surface where the P+ type doped layer is arranged, with the third functional layer arranged between the first functional layer and the first diffusion layer or between the second functional layer and the doped crystalline silicon layer; and forming a first electrode in an ohmic contact with the first diffusion layer, and forming a second electrode in an ohmic contact with the doped crystalline silicon layer.

53. The preparation method according to any one of claims 30 to 51, wherein the step of preparing the passivated contact structure involves sequentially forming the dielectric layer and the amorphous film layer on the first surface of the silicon wafer followed by the annealing treatment to form a passivation oxide layer proximate to the first surface and a doped crystalline silicon layer away from the first surface; and
the preparation method further comprises a post-treatment step after the step of preparing the passivated contact structure, and the post-treatment step involves: preparing a second diffusion layer on the second surface of the silicon wafer, wherein one of the second diffusion layer and the doped crystalline silicon layer is a P+ type doped layer, and the other of the second diffusion layer and the doped crystalline silicon layer is an N+ type doped layer; forming a first functional layer on the doped crystalline silicon layer and forming a second functional layer on the second diffusion layer; forming a third functional layer on the surface where the P+ type doped layer is arranged, with the third functional layer arranged between the first functional layer and the doped crystalline silicon layer or between the second functional layer and the second diffusion layer; and forming a first electrode in an ohmic contact with the doped crystalline silicon layer, and forming a second electrode in an ohmic contact with the second diffusion layer.

54. The preparation method according to any one of claims 30 to 51, wherein the step of preparing the passivated contact structure comprises: forming the dielectric layer and the amorphous film layer on each of the first surface and the second surface of the silicon wafer followed by an annealing treatment to form a first passivated contact structure arranged on the first surface and a second passivated contact structure located on the second surface, wherein the first passivated contact structure comprises a first passivation oxide layer proximate to the first surface and a first doped crystalline silicon layer away from the first surface, the second passivated contact structure comprises a second passivation oxide layer proximate to the second surface and a second doped crystalline silicon layer away from the second surface, one of the first doped crystalline silicon layer and the second doped crystalline silicon layer is a P+ type doped layer, and the other of the first doped crystalline silicon layer and the second doped crystalline silicon layer is an N+ type doped layer; and
the preparation method further comprises a post-treatment step after the step of preparing the passivated contact structure, and the post-treatment step involves: forming a first functional layer on the first doped crystalline silicon layer and forming a second functional layer on the second doped crystalline silicon layer; forming a third functional layer on the surface where the P+ type doped layer is arranged, with the third functional layer arranged between the first functional layer and the first doped crystalline silicon layer or between the second functional layer and the second doped crystalline silicon layer; and forming a first electrode in an ohmic contact with the first doped crystalline silicon layer, and forming a second electrode in an ohmic contact with the second doped crystalline silicon layer.

55. A photovoltaic module, comprising the solar cell according to any one of claims 9 to 29.
